# EUROPÄISCHE PATENTSCHRIFT

(11) **EP 3 814 793 B1**
(45) Veröffentlichungstag und Bekanntmachung des Hinweises auf die Patenterteilung: **24.08.2022**
(21) Anmeldenummer: 19736313.8
(22) Anmeldetag: 24.06.2019
(51) Int. Cl.: G01R 33/00, G01R 33/02

(54) **VERFAHREN UND VORRICHTUNG ZUR LAGEBESTIMMUNG EINES AUF EINEM SUBSTRAT ANGEORDNETEN BAUTEILS**
METHOD AND DEVICE FOR DETERMINING THE POSITION OF A COMPONENT ARRANGED ON A SUBSTRATE
PROCÉDÉ ET DISPOSITIF DE DÉTERMINATION DE POSITION D'UN COMPOSANT AGENCÉ SUR UN SUBSTRAT

(30) Priorität: 29.06.2018 DE 102018210735
(43) Veröffentlichungstag der Anmeldung: 05.05.2021
(73) Patentinhaber: Fraunhofer-Gesellschaft zur Förderung der angewandten Forschung e.V., 80686 München (DE)
(72) Erfinder: BERAN, Philip, 91058 Erlangen (DE)
(74) Vertreter: Hersina, Günter
(86) Internationale Anmeldenummer: PCT/EP2019/066652
(87) Internationale Veröffentlichungsnummer: WO 2020/002220

(56) Entgegenhaltungen:
- DE-A1-102010 028 390
- DE-B4-102010 028 390
- JP-A- 2010 147 048
- US-A1- 2013 255 381
- US-A1- 2014 159 766

## Beschreibung

Die Erfindung betrifft ein Verfahren und eine Vorrichtung zur Lagebestimmung eines auf einem Substrat angeordneten Bauteils, und insbesondere eine Leiterbahnanordnung zur Lagebestimmung von Magnetfeldsensoren.

Beim Auflöten von Bauteilen auf Leiterplatten sind stets Ungenauigkeiten hinsichtlich der späteren Ausrichtung hinzunehmen. Dies kommt sowohl durch sogenanntes "Aufschwimmen" beim Auflöten von Bauteilen (z.B. bei elektrischer Kontaktierung mittels Ball Grid Array) als auch durch maschinelle Toleranzen beim Bestücken der Leiterplatte zustande.

Gerade im Hinblick auf integrierte Schaltungen, wie beispielsweise Sensoren, ist zusätzlich die Lage des physikalischen Sensors im Halbleitermaterial (z.B. Silizium) als auch im Bauteil-Package selbst nicht exakt bekannt und immer mit Ungenauigkeiten behaftet. Dies wird zum einen durch das Sägen der einzelnen Dies aus einem Wafer verursacht, wo stets Toleranzen bei Sägebreite und Sägerichtung vorhanden sind. Zum anderen ist die Position des Dies beim Einbringen in ein Package ebenfalls mit Ungenauigkeiten behaftet.

Dies hat zur Folge, dass in Sensorik-Anwendungen weder der exakte Ort noch die vektorielle Orientierung der Messgröße bekannt sind und der Messwert darum nur als Absolutwert verwendet werden kann. Sobald aus dem Absolutwert relative Aussagen wie Abstand und Messrichtung abgeleitet werden sollen, ist dies nicht fehlerfrei möglich.

Bei Magnetfeldsensoren beispielsweise dient meist die Leiterplatte als Bezugsfläche für das Koordinatensystem bei einer Magnetfeldmessung. Allerdings haben Lage und Orientierung des Sensors relativ zur Leiterplatte einen erheblichen Einfluss auf das zu messende Magnetfeld. Gerade beim Aufbau von sogenannten Sensorarrays, innerhalb derer mehrere diskrete Sensoren dasselbe Magnetfeld messen sollen, sollten Lage und Orientierung der einzelnen Sensoren bekannt sein, um sie bei der Auswertung entsprechend berücksichtigen zu können. Dieses Problem betrifft auch jede andere Sensorikanwendung, bei der es wichtig ist, die exakte Lage und den Ort der Messung zu kennen.

Heutzutage lässt sich die Position eines Bauteils auf einer Leiterplatte mit den entsprechenden Toleranzen für die Leiterplattenfertigung, für die Fertigung des Sensors selbst (z.B. im Falle einer integrieren Schaltung), für die Platziergenauigkeit im Package und für die Genauigkeit während des Bestückens und Auflötens angeben. Für die meisten Anwendungen ist dies ausreichend, da entweder nur Absolutwerte benötigt werden oder die genannten Toleranzen durch Einmessen des Systems kompensiert werden können. Eine übliche optische Kontrolle nach der Bestückung liefert zwar die Position des Bauteils, aber nicht die Position des Sensors innerhalb des Bauteils und eine eventuelle Verkippung desselbigen innerhalb des Bauteils.

Weitere bekannte Ansätze zur Lösung dieses Problems beruhen auf optischer Vermessung von Leiterplatten und deren Bauteilen, wodurch auch die Position des Sensors bestimmt werden kann. Dies funktioniert aber nur bei Bauteilen, wo die Schaltungsseite sichtbar ist, was in der Praxis nahezu nie der Fall ist, da die Schaltung im Package verborgen ist oder durch sogenannte Flip-Chip Montage zur Leiterplatte zeigt und nicht sichtbar ist.

Auch durch Röntgen der Leiterplatte kann unter Umständen die Sensorposition gefunden werden, was in einem Produktionsprozess jedoch mit großem Aufwand verbunden ist. Der gravierende Nachteil bei den genannten Lösungen ist stets, dass der Aufwand immer größer wird, wenn die Sensorposition noch genauer bestimmt werden soll.

Die US 2014 / 0159766 A1 beschreibt ein HF-Modul mit einem HF-Chip, der mittels Bumps auf einem Substrat angeordnet ist. Diese Bumps wirken als Antennen, die elektromagnetische Wechselfelder aussenden bzw. empfangen. Mittels der Bumps wird ein Testsignal ausgesendet bzw. empfangen. Mit Hilfe dieses Testsignals kann bestimmt werden, ob die Bumps eine vordefinierte Höhe unter- bzw. überschreiten.

Z Die DE102004047770A1 beschreibt ein Verfahren zur Kompensation von Versatzfehlern zwischen einem Permanentmagenten und einem Magnetfeldsensor, welche beide auf einem Substrat angeordnet sind, mittels der Erzeugung eines Kompensationsfeldes.

J Es wäre demnach wünschenswert, ein Verfahren zur Lagebestimmung eines auf einem Substrat angeordneten Bauteils bereitzustellen, welches mit geringem Aufwand durchführbar ist und gleichzeitig hochpräzise und kostengünstig in der Massenfertigung von elektrischen und elektronischen Bauteilen und Komponenten einsetzbar ist. Selbiges gilt analog für eine erfindungsgemäße Vorrichtung zur Lagebestimmung eines auf einem Substrat angeordneten Bauteils.

Daher werden ein Verfahren mit den Merkmalen von Anspruch 1 sowie eine entsprechende Vorrichtung mit den Merkmalen von Anspruch 17 vorgeschlagen. Ausführungsformen und weitere vorteilhafte Aspekte sind in den jeweils abhängigen Patentansprüchen genannt.

Ein erster Aspekt der Erfindung betrifft ein Verfahren zur Lagebestimmung eines auf einem Substrat angeordneten Bauteils mittels Erfassung eines statischen magnetischen Felds. Bei dem erfindungsgemäßen Verfahren wird zunächst ein Substrat bereitgestellt, wobei an dem Substrat mindestens ein Magnetfeldsensor angeordnet ist. Der Magnetfeldsensor kann selbst das Bauteil darstellen, dessen Lage relativ zu dem Substrat bestimmt werden soll. Es ist aber auch vorstellbar, dass der Magnetfeldsensor in einem Bauteil verbaut bzw. integriert ist, wobei dann die Lage dieses Bauteils relativ zu dem Substrat bestimmt werden kann. Dies wäre insbesondere bei integrierten Schaltungen vorstellbar. Dabei kann beispielsweise der Magnetfeldsensor in das Halbleitermaterial des Bauteils beziehungsweise der integrierten Schaltung mit integriert sein. Es ist auch denkbar, dass das Bauteil, dessen Lage bestimmt werden soll, in einem Package angeordnet ist, wobei der Magnetfeldsensor ebenfalls in ebendiesem Package angeordnet sein kann. Das erfindungsgemäße Verfahren weist ferner einen Schritt des Erzeugens einer zweckgebundenen Leiterbahnstruktur auf dem Substrat auf. Die zweckgebundene Leiterbahnstruktur dient dabei zum Zwecke des Erzeugens eines statischen magnetischen Felds mit bekannter Feldverteilung. Das heißt, es wird nicht willkürlich irgend ein statisches magnetisches Feld erzeugt, sondern es wird bewusst ein statisches magnetisches Feld erzeugt, dessen Feldverteilung bekannt ist, beispielsweise indem die Feldverteilung mittels zuvor durchgeführter Modellberechnungen ermittelt wird. Die zweckgebundene Leiterbahnstruktur kann dabei eigens und exklusiv nur für die Erzeugung des statischen magnetischen Felds mit der bekannten Feldverteilung vorgesehen sein. Es ist aber auch denkbar, dass bereits vorhandene Leiterbahnstrukturen zum Zwecke der Erzeugung des statischen magnetischen Felds mit der bekannten Feldverteilung verwendet werden können. An die zweckgebundene Leiterbahnstruktur wird eine elektrische Spannung angelegt, sodass die zweckgebundene Leiterbahnstruktur das statische magnetische Feld mit der bekannten Feldverteilung erzeugt. Diese an die zweckgebundene Leiterbahnstruktur angelegte Spannung kann im Vergleich zu der ansonsten auf dem Substrat verwendeten Spannung, die zur reinen Bauteilversorgung dient, deutlich größer sein. Aus diesem Grund ist es vorteilhaft, wenn, wie zuvor erwähnt, eine eigens und exklusiv nur für die Erzeugung des statischen magnetischen Felds mit der bekannten Feldverteilung vorgesehene zweckgebundene Leiterbahnstruktur vorgesehen ist. Die zweckgebundene Leiterbahnstruktur kann demnach zusätzlich zu den ansonsten vorhandenen, und zur Bauteilversorgung dienenden, Leiterbahnen vorgesehen sein. Aufgrund der zur Erzeugung des statischen magnetischen Felds nötigen höheren Spannung im Vergleich zur Versorgungsspannung zur Energieversorgung der Bauteile kann die zweckgebundene Leiterbahnstruktur eine größere Ausdehnung auf dem Substrat aufweisen als die zur Bauteilversorgung dienenden Leiterbahnen. Erfindungsgemäß kann das mittels der zweckgebundenen Leiterbahnstruktur erzeugte statische magnetische Feld mit dem Magnetfeldsensor erfasst werden. Da dieses statische magnetische Feld eine bekannte Feldverteilung aufweist, kann basierend auf der Erfassung des statischen magnetischen Felds, die Lage des Magnetfeldsensors, und somit die Lage des Bauteils, relativ zu der zweckgebundenen Leiterbahnstruktur und somit relativ zu dem Substrat bestimmt werden. Hierfür kann es sich bei dem Magnetfeldsensor insbesondere um einen vektoriell messenden Magnetfeldsensor handeln, wobei dieser ausgestaltet ist, um die vektorielle Feldverteilung aller drei Raumachsen zu messen. Dementsprechend kann die vektorielle Orientierung der Messgröße, d.h. des statischen magnetischen Felds, bestimmt werden. Durch exakte Messung des Feldvektors des statischen magnetischen Felds lässt sich so auf die Position des Magnetfeldsensors relativ zur Quelle des statischen magnetischen Felds, d.h. zu der Leiterbahnstruktur, schließen. Dies kann über diverse Ansätze berechnet werden, wie beispielsweise eine inverse Lösung der Maxwell-Gleichungen oder über eine Modellierung des statischen magnetischen Felds und die Optimierung des Messwertes an dieses Modell mittels geeigneter Algorithmen. Die in dieser Erfindung skizzierte Lösung kommt mit einfachen Mitteln aus und lässt sich mit wenig Zusatzaufwand sogar im Betrieb wiederholen.

Ein zweiter Aspekt der Erfindung betrifft eine Vorrichtung zur Lagebestimmung eines auf einem Substrat angeordneten Bauteils mittels Erfassung eines statischen magnetischen Felds. Bezüglich der Vorteile der erfindungsgemäßen Vorrichtung gegenüber dem Stand der Technik wird auf die oberen Absätze verwiesen.

Ebenfalls hierin offenbart, aber nicht zu der hier beschriebenen Erfindung zugehörig, ist ein Verfahren zur Lagebestimmung eines auf einem Substrat angeordneten Bauteils mittels Erfassung eines elektrostatischen Felds. Hierbei wird zunächst ein Substrat bereitgestellt, wobei auf dem Substrat mindestens ein kapazitiver Sensor zum Erfassen eines elektrostatischen Felds angeordnet ist. Außerdem wird eine zweckgebundene Leiterbahnstruktur auf dem Substrat erzeugt, wobei die zweckgebundene Leiterbahnstruktur zum Zwecke des Erzeugens eines elektrostatischen Felds mit bekannter Feldverteilung vorgesehen ist. Beispielsweise kann die zweckgebundene Leiterbahnstruktur mindestens zwei Leiterbahnen aufweisen, die derart zueinander angeordnet sind, dass sich zwischen den Leiterbahnen ein elektrostatisches Feld ausbildet. Alternativ kann die zweckgebundene Leiterbahnstruktur mindestens eine Leiterbahn aufweisen, wobei sich in diesem Falle zwischen der Leiterbahn und dem kapazitiven Sensor ein elektrostatisches Feld ausbilden kann. Ferner wird in dem erfindungsgemäßen Verfahren eine elektrische Spannung an die zweckgebundenen Leiterbahnstruktur angelegt, sodass die zweckgebundene Leiterbahnstruktur das soeben erwähnte elektrostatische Feld mit der bekannten Feldverteilung erzeugt. Das heißt, es wird nicht willkürlich irgend ein elektrostatisches Feld erzeugt, sondern es wird bewusst ein elektrostatisches Feld erzeugt, dessen Feldverteilung bekannt ist, beispielsweise indem die Feldverteilung mittels zuvor durchgeführter Modellberechnungen ermittelt wird. Gemäß dem erfindungsgemäßen Verfahren wird das erzeugte elektrostatische Feld mit der bekannten Feldverteilung mittels des kapazitiven Sensors erfasst. Anschließend wird die Lage des Bauteils relativ zu dem Substrat bestimmt, und zwar basierend auf der vorangegangenen Erfassung des elektrostatischen Felds mit der bekannten Feldverteilung.

Ebenfalls hierin offenbart, aber auch nicht zu der hier beschriebenen Erfindung zugehörig, ist eine Vorrichtung zur Lagebestimmung eines auf einem Substrat angeordneten Bauteils mittels Erfassung eines elektrostatischen Felds. Bezüglich der Vorteile der erfindungsgemäßen Vorrichtung gegenüber dem Stand der Technik wird auf die oberen Absätze betreffend den dritten Aspekt der Erfindung verwiesen.

Einige Ausführungsbeispiele sind exemplarisch in der Zeichnung dargestellt und werden nachstehend erläutert. Es zeigen:
- Fig. 1A: ein schematisches Blockdiagramm zur Darstellung einzelner Verfahrensschritte des erfindungsgemäßen Verfahrens gemäß einer Ausführungsform,
- Fig. 1B: ein schematisches Blockdiagramm zur Darstellung einzelner Verfahrensschritte eines nicht zur vorliegenden Erfindung gehörigen Verfahrens,
- Fig. 2: eine seitliche Darstellung einer erfindungsgemäßen Vorrichtung gemäß eines Ausführungsbeispiels,
- Fig. 3: eine Draufsicht auf die erfindungsgemäße Vorrichtung aus Figur 2,
- Fig. 4: eine seitliche Darstellung einer nicht zur Erfindung gehörigen Vorrichtung,
- Fig. 5: eine Draufsicht auf die Vorrichtung aus Figur 4,
- Fig. 6: eine Draufsicht auf eine erfindungsgemäße Vorrichtung gemäß eines weiteren Ausführungsbeispiels,
- Fig. 7: eine seitliche Darstellung einer erfindungsgemäßen Vorrichtung gemäß eines weiteren Ausführungsbeispiels, und
- Fig. 8: eine Draufsicht auf die erfindungsgemäße Vorrichtung aus Figur 7.

Im Folgenden werden Ausführungsbeispiele mit Bezug auf die Figuren näher beschrieben, wobei Elemente mit derselben oder ähnlichen Funktion mit denselben Bezugszeichen versehen sind.

Verfahrensschritte, die in einem Blockdiagramm dargestellt und mit Bezugnahme auf das selbige erläutert werden, können auch in einer anderen als der abgebildeten beziehungsweise beschriebenen Reihenfolge ausgeführt werden. Außerdem sind Verfahrensschritte, die ein bestimmtes Merkmal einer Vorrichtung betreffen mit ebendiesem Merkmal der Vorrichtung austauschbar, was ebenso anders herum gilt.

Außerdem werden nachfolgend Magnetfeldsensoren, und insbesondere vektoriell messende Magnetfeldsensoren, als eine Vorrichtung zum Erfassen eines elektromagnetischen Felds beschrieben. Ferner wird ein Magnetfeld synonym zu dem Begriff eines statischen magnetischen Felds verwendet, das heißt, die Begriffe statisches magnetisches Feld, Elektromagnetfeld und Magnetfeld sind hierin untereinander austauschbar.

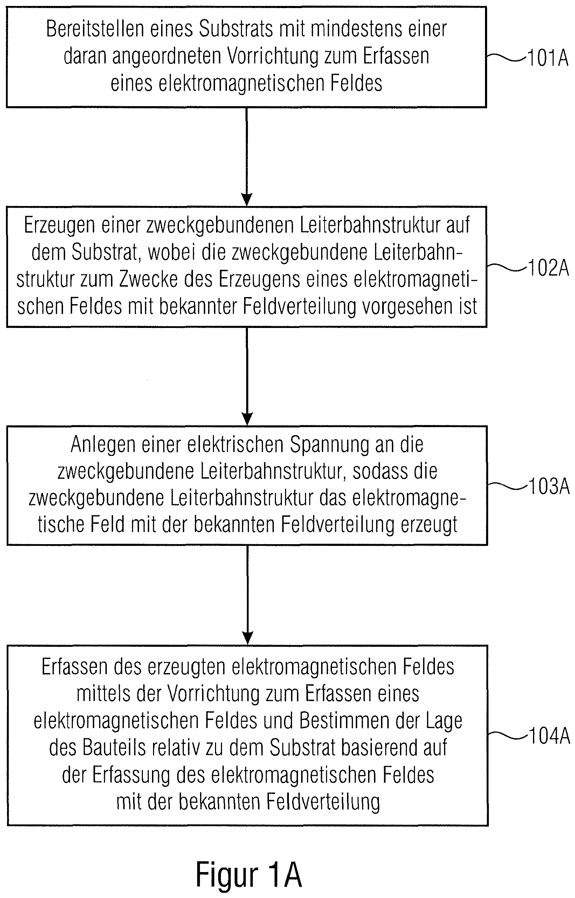

Figur 1A zeigt ein Blockdiagramm zur Darstellung des erfindungsgemäßen Verfahrens gemäß einer Ausführungsform.

In Block 101A wird ein Substrat mit mindestens einer daran angeordneten Vorrichtung zum Erfassen eines elektromagnetischen Felds bereitgestellt, wobei es sich bei der besagten Vorrichtung zum Erfassen eines elektromagnetischen Felds um einen Magnetfeldsensor handelt.

In Block 102A wird eine zweckgebundene Leiterbahnstruktur auf dem Substrat erzeugt, wobei die zweckgebundene Leiterbahnstruktur zum Zwecke des Erzeugens eines statischen magnetischen Felds mit bekannter Feldverteilung vorgesehen ist.

In Block 103A wird eine elektrische Spannung an die zweckgebundene Leiterbahnstruktur angelegt, sodass die zweckgebundene Leiterbahnstruktur das statische magnetische Feld mit der bekannten Feldverteilung erzeugt.

In Block 104A wird das erzeugte statisches magnetisches Feld mittels der Vorrichtung zum Erfassen eines elektromagnetischen Felds, d.h. mittels des Magnetfeldsensors, erfasst und die Lage des Bauteils relativ zu dem Substrat wird basierend auf der Erfassung des statisches magnetisches Felds mit der bekannten Feldverteilung bestimmt.

Wie eingangs bereits erwähnt wurde, kann der Magnetfeldsensor selbst das Bauteil darstellen, dessen Lage relativ zu dem Substrat bestimmt werden soll. Alternativ kann der Magnetfeldsensor in einem Bauteil, dessen Lage relativ zu dem Substrat bestimmt werden soll, integriert sein. Alternativ kann der Magnetfeldsensor an einem Bauteil, dessen Lage relativ zu dem Substrat bestimmt werden soll, angeordnet sein.

Das Verfahren kann ferner einen Schritt des Bestimmens der Feldverteilung des mittels der zweckgebundenen Leiterbahnstruktur erzeugten statischen magnetischen Felds aufweisen. Somit ist die Feldverteilung des erzeugten statischen magnetischen Felds anschließend bekannt und das statische magnetische Feld wird somit zu einem statischen magnetischen Feld mit bekannter Feldverteilung. Das Bestimmen der Feldverteilung wird vorteilhafter Weise vor dem Bestimmen der Lage des Bauteils durchgeführt.

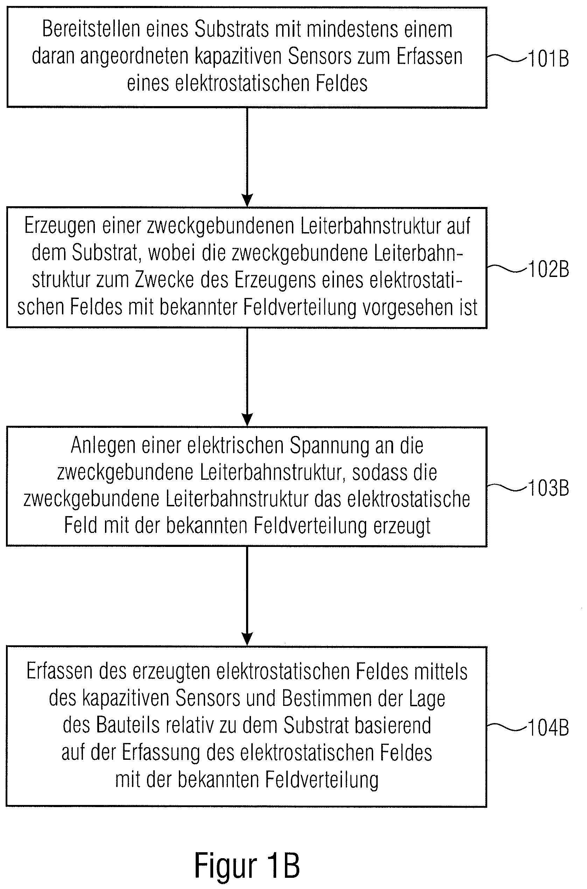

Figur 1B zeigt ein Blockdiagramm zur Darstellung eines nicht zu der hierin beschriebenen Erfindung gehörigenVerfahrens. Anstelle eines statischen magnetischen Feldes, wie in Figur 1A beschrieben, wird hier in Figur 1B ein elektrostatisches Feld erzeugt.

In Block 101B wird ein Substrat mit mindestens einem daran angeordneten kapazitiven Sensor zum Erfassen eines elektrostatischen Felds bereitgestellt.

In Block 102B wird eine zweckgebundene Leiterbahnstruktur auf dem Substrat erzeugt, wobei die zweckgebundene Leiterbahnstruktur zum Zwecke des Erzeugens eines elektrostatischen Felds mit bekannter Feldverteilung vorgesehen ist.

In Block 103B wird eine elektrische Spannung an die zweckgebundene Leiterbahnstruktur angelegt, sodass die zweckgebundene Leiterbahnstruktur das elektrostatische Feld mit der bekannten Feldverteilung erzeugt.

In Block 104B wird das erzeugte elektrostatische Feld mittels des kapazitiven Sensors erfasst, und die Lage des Bauteils relativ zu dem Substrat wird basierend auf der Erfassung des elektrostatischen Felds mit der bekannten Feldverteilung bestimmt.

Wie eingangs bereits erwähnt, kann der kapazitive Sensor selbst das Bauteil darstellen, dessen Lage relativ zu dem Substrat bestimmt werden soll. Alternativ kann der kapazitive Sensor in einem Bauteil, dessen Lage relativ zu dem Substrat bestimmt werden soll, integriert sein. Alternativ kann der kapazitive Sensor an einem Bauteil, dessen Lage relativ zu dem Substrat bestimmt werden soll, angeordnet sein.

Das Verfahren kann ferner einen Schritt des Bestimmens der Feldverteilung des zwischen den zweckgebundenen Leiterbahnstrukturen erzeugten elektrostatischen Felds aufweisen. Somit ist die Feldverteilung des erzeugten elektrostatischen Felds anschließend bekannt und das elektrostatische Feld wird somit zu einem elektrostatischen Feld mit bekannter Feldverteilung. Das Bestimmen der Feldverteilung wird vorteilhafter Weise vor dem Bestimmen der Lage des Bauteils durchgeführt.

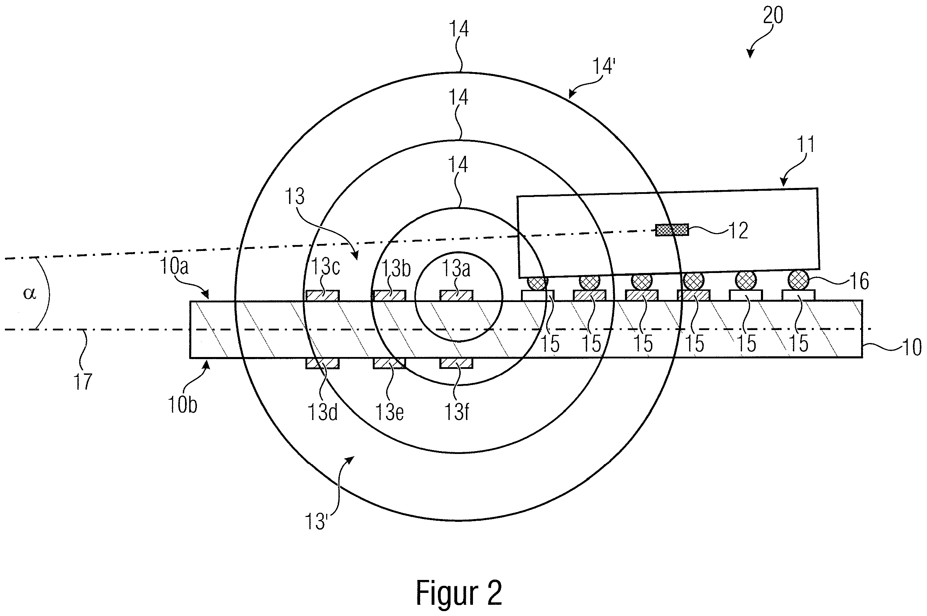

Figur 2 zeigt eine schematische Seitenansicht einer erfindungsgemäßen Vorrichtung 20 gemäß einem Ausführungsbeispiel, anhand dessen nachfolgend auch das erfindungsgemäße Verfahren weiter beschrieben werden soll.

Die Vorrichtung 20 weist ein Substrat 10 auf. Auf dem Substrat 10 ist ein Bauteil 11 angeordnet, dessen Lage relativ zu dem Substrat 10 mit dem erfindungsgemäßen Verfahren bestimmt werden kann. Bei diesem Bauteil 11 kann es sich beispielsweise um eine integrierte Schaltung handeln, die eine Vorrichtung 12 zum Erfassen eines elektromagnetischen Felds aufweist.

Bei einer Vorrichtung 12 zum Erfassen eines elektromagnetischen Felds kann es sich beispielsweise um eine Antenne handeln. Vorzugsweise kann es sich hierbei um eine Antenne mit bekannter Strahlungscharakteristik handeln.

Erfindungsgemäß handelt es sich bei der Vorrichtung 12 um einen Magnetfeldsensor, und insbesondere um einen vektoriellen Magnetfeldsensor. Im Folgenden wird die Vorrichtung 12 am Beispiel eines solchen Magnetfeldsensors beschrieben.

Wie oben erwähnt, kann das Bauteil 11, dessen Lage bestimmt werden soll, beispielsweise eine integrierte Schaltung aufweisen, wobei diese integrierte Schaltung wiederum einen Magnetfeldsensor 12 aufweisen kann. Demnach kann es sich bei dem Bauteil 11 selbst um den Magnetfeldsensor 12 handeln, dessen Lage relativ zu dem Substrat 10 mit dem erfindungsgemäßen Verfahren bestimmt werden kann.

Das Substrat 10 kann beispielsweise eine, auch als PCB (engl.: Printed Circuit Board) bezeichnete, Leiterplatte sein. Auf dem Substrat 10 können eine oder mehrere Leiterbahnen 15 vorhanden sein, die zur Energieversorgung eines oder mehrerer auf dem Substrat 10 angeordneter Bauteile vorgesehen sind.

Erfindungsgemäß ist auf dem Substrat 10 eine zweckgebundene Leiterbahnstruktur 13 vorgesehen. Die zweckgebundene Leiterbahnstruktur 13 kann, wie hier exemplarisch abgebildet ist, mehrere Leiterbahnen 13a-13f aufweisen. Die zweckgebundene Leiterbahnstruktur 13 kann aber auch lediglich eine einzelne Leiterbahn 13a aufweisen. Der Übersichtlichkeit wegen werden die erfindungsgemäße Vorrichtung 20 sowie das erfindungsgemäße Verfahren im Folgenden exemplarisch anhand einer einzelnen Leiterbahn 13a erläutert, wobei alle diesbezüglichen Erläuterungen gleichsam auch für optional vorhandene zusätzliche Leiterbahnen 13b-13f der Leiterbahnstruktur 13 gelten.

Wie außerdem in Figur 2 zu erkennen ist, kann die Leiterbahnstruktur 13 auf derselben Seite 10a des Substrats 10 angeordnet sein wie der Magnetfeldsensor 12. Dies gilt im vorliegenden Ausführungsbeispiel für die in Figur 2 abgebildete obere Leiterbahnstruktur 13, die die Leiterbahnen 13a, 13b, 13c aufweisen kann. Alternativ oder zusätzlich kann die Leiterbahnstruktur 13, beziehungsweise eine weitere Leiterbahnstruktur, auf der dem Magnetfeldsensor 12 gegenüberliegenden Seite 10b des Substrats 10 angeordnet sein. Dies gilt im vorliegenden Ausführungsbeispiel für die in Figur 2 abgebildete untere Leiterbahnstruktur 13', die die Leiterbahnen 13d, 13e, 13f aufweisen kann.

Weitere (hier nicht explizit abgebildete) Ausführungsbeispiele sehen vor, dass der Schritt des Erzeugens der zweckgebundenen Leiterbahnstruktur 13 auf dem Substrat 10 beinhaltet, dass die zweckgebundene Leiterbahnstruktur 13 als eine in das Substrat 10 integrierte vergrabene Leiterbahnstruktur ausgebildet wird. Das heißt, die Leiterbahnstruktur 13 kann eine oder mehrere Leiterbahnen 13a-13f aufweisen, wovon mindestens eine Leiterbahn 13a-13f in dem Substrat 10 integriert ist, beispielsweise in Form einer vergrabenen Leiterbahn. Außerdem könnte das Verfahren auch mit gedruckten Leiterbahnen (2D und 3D) realisiert werden.

Das hier exemplarisch abgebildete Bauteil 11, beziehungsweise der erfindungsgemä-ßeMagnetfeldsensor 12, ist an den zur Bauteilversorgung dienenden Leiterbahnen 15 angeordnet bzw. angeschlossen. Eine Möglichkeit hierfür sind die hier lediglich beispielhaft abgebildeten Lotkugeln 16, die auch als Solder Balls bezeichnet werden. Wie zu erkennen ist, kann beim Anordnen des Bauteils 11 auf den Leiterbahnen 15 eine Verkippung des Bauteils 11 bzw. des Magnetfeldsensors 12 erfolgen. In diesem Beispiel ist der Magnetfeldsensor 12 beispielsweise um einen Winkel α gegenüber der Substratebene 17 verkippt. Dies kann sowohl durch sogenanntes "Aufschwimmen" beim Auflöten des Bauteils 11 bzw. des Magnetfeldsensors 12 (z.B. bei elektrischer Kontaktierung mittels Ball Grid Array) als auch durch maschinelle Toleranzen beim Bestücken des Substrats 10 zustande kommen.

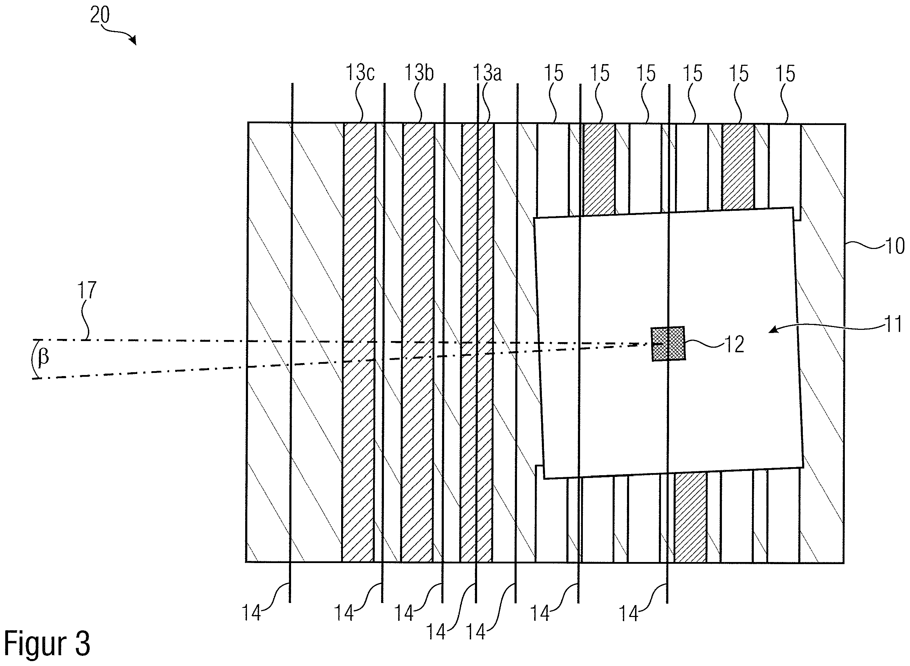

Alternativ oder zusätzlich können weitere (hier nicht explizit dargestellte) Verkippungen des Magnetfeldsensors 12 relativ zu dem Substrat 10, beispielsweise bei der Integration des Magnetfeldsensors 12 in dessen Halbleitermaterial, auftreten. Außerdem können beim Anordnen des Magnetfeldsensors 12 neben einer Verkippung weitere Lageänderungen gegenüber dem Substrat 10 auftreten, beispielsweise eine Verdrehung relativ zur Substratebene 17, wie dies beispielhaft in der in Figur 3 abgebildeten Draufsicht erkennbar ist. Hier ist der Magnetfeldsensor 12, alternativ oder zusätzlich zur Verkippung um den Winkel a, um einen Rotationswinkel β zu der Substratebene 17 verdreht.

Generell kann mit dem erfindungsgemäßen Verfahren, beziehungsweise mit der erfindungsgemäßen Vorrichtung 20, die räumliche Orientierung bzw. die Lage des Magnetfeldsensors 12, und somit des Bauteils 11, relativ zu dem Substrat 10 in allen drei Raumrichtungen bestimmt werden.

Hierfür kann erfindungsgemäß an die eingangs erwähnte zweckgebundene Leiterbahnstruktur 13 eine elektrische Spannung angelegt werden, sodass ein entsprechender Strom durch die Leiterbahnstruktur 13 fließt, der wiederum ein Magnetfeld 14' erzeugt. In den Figuren 2 und 3 sind schematisch mehrere Feldlinien 14 eingezeichnet, die das von der zweckgebundenen Leiterbahnstruktur 13 erzeugte Magnetfeld 14' repräsentieren.

Sofern die Vorrichtung 12 zum Erfassen eines elektromagnetischen Felds als eine Antenne ausgebildet ist, kann eine hochfrequente Wechselspannung an die Leiterbahnstruktur 13 angelegt werden, sodass ein Wechselstrom durch die Leiterbahnstruktur 13 fließt, der wiederum ein elektromagnetisches Wechselfeld 14' erzeugt, von dem sich elektromagnetische Freiraumwellen ablösen können, die wiederum mit der Antenne 12 erfasst bzw. empfangen werden können. Die Leiterbahnstruktur 13 würde demnach eine Sendeantenne darstellen, und die Vorrichtung 12 zum Erfassen eines elektromagnetischen Felds würde demnach eine Empfangsantenne darstellen. Dies stellt jedoch keine Ausführungsform der Erfindung dar.

Sofern die Vorrichtung 12 erfindungsgemäß jedoch als ein Magnetfeldsensor ausgebildet ist, kann eine Gleichspannung oder eine ausreichend niederfrequente Wechselspannung an die Leiterbahnstruktur 13 angelegt werden, sodass ein statisches bzw. quasistatisches Elektromagnetfeld erzeugt wird, das wiederum mit dem Magnetfeldsensor 12 erfasst werden kann.

In den vorliegenden Ausführungsbeispielen kann die zweckgebundene Leiterbahnstruktur 13 derart ausgestaltet sein, dass mindestens eine Leiterbahn 13a als eine Gerade ausgestaltet ist. Hierbei kann die mindestens eine Leiterbahn 13a zumindest in einem Abschnitt, in dem die Leiterbahn 13a seitlich an dem Magnetfeldsensor 12 entlang vorbeiläuft, als eine Gerade ausgestaltet sein. Es ist aber auch vorstellbar, dass die mindestens eine Leiterbahn 13a über das gesamte Substrat 10 hinweg in Form einer Geraden verläuft.

Eine solche, als Gerade ausgestaltete, Leiterbahn 13a erzeugt ein Magnetfeld 14' mit einer homogenen Feldverteilung. Das heißt die hierbei entstehende Feldverteilung ist bekannt, beziehungsweise kann mit einfachen Mitteln bestimmt werden. Die magnetischen Feldlinien 14 können sich hierbei als Äquipotentiallinien konzentrisch um die gerade Leiterbahn 13a herum ausbreiten.

Alternativ oder zusätzlich ist es denkbar, dass die zweckgebundene Leiterbahnstruktur 13 als eine Spulenstruktur mit mindestens zwei parallel zueinander angeordneten Leiterbahnen ausgestaltet ist.

Unabhängig von der konkreten geometrischen Ausgestaltung der zweckgebundenen Leiterbahnstruktur 13 ist es vorteilhaft, wenn die zweckgebundene Leiterbahnstruktur 13 möglichst nahe neben dem Magnetfeldsensor 12 entlang verläuft. Gemäß Ausführungsbeispielen ist es denkbar, dass die zweckgebundene Leiterbahnstruktur 13 nur eine geringe Beabstandung im Bereich von wenigen Millimetern zu dem Magnetfeldsensor 12 beziehungsweise zu dem Bauteil 11 aufweist. Vorteilhafter Weise verläuft die zweckgebundene Leiterbahnstruktur 13 direkt bzw. unmittelbar neben dem Bauteil 11 entlang, das heißt ohne weitere dazwischen angeordnete Leiterbahnen oder anderen Strukturen und/oder Bauteilen.

Aufgrund der geometrischen Nähe zwischen der zweckgebundenen Leiterbahnstruktur 13 und dem Magnetfeldsensor 12 kann es bereits ausreichend sein, lediglich eine geringe Spannung von wenigen Volt an die zweckgebundene Leiterbahnstruktur 13 anzulegen, um ein dementsprechend kleines Magnetfeld 14' zu erzeugen, welches jedoch zur Durchführung des erfindungsgemäßen Verfahrens ausreichend stark ist.

Um nun die Lage des Magnetfeldsensors 12 im Raum beziehungsweise relativ zu dem Substrat 10 zu bestimmen, ist es vorteilhaft, wenn der Magnetfeldsensor 12 von vornherein mit ausreichender Genauigkeit kalibriert ist und einen möglichst geringen Messfehler aufweist. Kalibriert bedeutet in diesem Zusammenhang, dass die Messfehler des Magnetfeldsensors 12 hinreichend bekannt sind und somit kompensiert werden können.

Der Magnetfeldsensor 12 ist vorzugsweise ein sogenannter vektoriell messender Magnetfeldsensor, der ausgestaltet ist, um die Orientierung des Feldvektors einer zu messenden Magnetfeldlinie zu bestimmen.

Durch exakte Messung des Feldvektors des mittels der zweckgebundenen Leiterbahnstruktur 13 erzeugten statischen magnetischen Felds 14' lässt sich so auf die Lage des Magnetfeldsensors 12 relativ zur Magnetfeldquelle, d.h. relativ zur zweckgebundenen Leiterbahnstruktur 13, schließen. Dabei ist es von Vorteil, wenn die Form des erzeugten Magnetfelds 14' sehr genau bekannt ist, um einen Rückschluss zuzulassen. Dies kann über diverse Ansätze berechnet werden, wie beispielsweise eine inverse Lösung des Satzes von Biot-Savart, oder der Maxwell-Gleichungen, oder über eine Modellierung des Magnetfelds 14' und die Optimierung des Messwertes an dieses Modell mittels geeigneter Algorithmen.

Somit kann also erfindungsgemäß mittels des Magnetfeldsensors 12 eine Messung des erzeugten statischen Magnetfelds 14' durchgeführt und die Raumlage des Magnetfeldsensors 12 relativ zu dem Substrat 10 bestimmt werden, und zwar basierend auf der vorangegangenen Messung des Magnetfelds 14', wobei dessen Feldverteilung bekannt ist.

Selbiges gilt auch, wenn anstatt eines Magnetfeldsensors eine Antenne als Vorrichtung 12 zum Erfassen eines elektromagnetischen Felds verwendet wird, was jedoch keine Ausführungsform der hierin beschriebenen Erfindung darstellt. Auch hier kann über die gemessene Feldverteilung auf die Lage der Antenne 12, und somit des Bauteils 11, relativ zu dem Substrat 10 rückgeschlossen werden, sofern die Feldverteilung 14 des elektromagnetischen Felds 14'bekannt ist.

Das statische magnetische Feld 14' kann vorzugsweise mittels der zweckgebundenen Leiterbahnstruktur 13 erzeugt werden. Dabei kann die zweckgebundene Leiterbahnstruktur 13 ausschließlich zum Zwecke des Erzeugens des statischen magnetischen Felds 14', das zur Bestimmung der Lage des Magnetfeldsensors 12, und somit des Bauteils 11, relativ zu dem Substrat 10 genutzt wird, auf dem Substrat 10 vorgesehen sein. In diesem Fall würde die zweckgebundene Leiterbahnstruktur 13 nicht dazu dienen, die auf dem Substrat 10 angeordneten Bauteile mit Energie zu versorgen.

Alternativ oder zusätzlich kann auch an den ein oder mehreren Leiterbahnen 15, die eigentlich zur Energieversorgung von auf dem Substrat 10 angeordneten Bauteilen vorgesehen sind, eine Spannung angelegt werden, um ein statisches magnetisches Feld 14' zur Bestimmung der Lage des Magnetfeldsensors 12, bzw. des Bauteils 11, relativ zu dem Substrat 10 zu erzeugen. Da die zur Energieversorgung vorgesehenen Leiterbahnen 15 jedoch in der Regel einen unstetigen und teils komplizierten Verlauf auf dem Substrat 10 aufweisen, ist die Feldverteilung meist schwierig zu bestimmen. Das Vorsehen der zweckgebundenen Leiterbahnstruktur 13 kann daher der Nutzung von bereits vorhandenen Leiterbahnen 15 zur Energieversorgung vorzuziehen sein.

Abgesehen davon kann an den zur Energieversorgung vorgesehenen Leiterbahnen 15 meist keine ausreichend hohe Spannung angelegt werden, um ein zur Durchführung des erfindungsgemäßen Verfahrens ausreichend starkes statisches magnetisches Feld zu erzeugen. Beispielsweise wird bei vielen elektrischen bzw. elektronischen Schaltungen nicht mehr als 6 Volt an den zur Energieversorgung vorgesehenen Leiterbahnen 15 angelegt, um die daran angeschlossenen Bauteile nicht zu beschädigen. Dementsprechend sind die Dimensionen der zur Energieversorgung vorgesehenen Leiterbahnen 15 nicht auf wesentlich größere Spannungen und Ströme ausgelegt.

Die ein oder mehreren Leiterbahnen 13a-13f der zweckgebundenen Leiterbahnstruktur 13 hingegen können beispielsweise eine größere Breite aufweisen als die zur Energieversorgung vorgesehenen Leiterbahnen 15, um somit größere Ströme leiten und dementsprechend ein stärkeres statisches magnetisches Feld erzeugen zu können.

Die zweckgebundene Leiterbahnstruktur 13 kann beispielsweise mittels gängiger Strukturierungsverfahren in das Substrat 10 strukturiert werden. Beispielsweise kann die zweckgebundene Leiterbahnstruktur 13 mittels eines Fotolithografieverfahrens in das Substrat 10 strukturiert werden. Ein Vorteil der Erfindung liegt hierbei darin, dass insbesondere Fotolithografieverfahren eine sehr hohe Präzision bei der Herstellung der zweckgebundenen Leiterbahnstruktur 13 erlauben. Dies kommt insbesondere der Bestimmung der Feldverteilung des mittels der zweckgebundenen Leiterbahnstruktur 13 erzeugbaren statischen magnetischen Felds 14' zugute. Durch die hohe Präzision bei der Herstellung der zweckgebundenen Leiterbahnstruktur 13 kann nämlich die Feldverteilung sehr nachvollziehbar beziehungsweise sehr homogen ausfallen, sodass eine Lagebestimmung des Magnetfeldsensors 12, bzw. des Bauteils 11, basierend auf der Feldverteilung des statischen magnetischen Felds 14' ebenfalls sehr präzise wird.

In anderen Worten kann also aufgrund der Herstellungsweise von z.B. Leiterplatten mittels optischer Belichtung eine sehr hohe Fertigungsgenauigkeit erreicht, die den Anforderungen an die Kenntnis der Form des statischen magnetischen Felds 14' genügen.

Gemäß einem weiteren denkbaren Ausführungsbeispiel kann eine differentielle Messung von zwei statischen magnetischen Feldern mit unterschiedlichen Feldstärken erfolgen, um beispielsweise Störfelder, und insbesondere statische Störfelder wie das Erdmagnetfeld, zu bestimmen und zu kompensieren. In diesem Falle wird die Lage des Bauteils 11 basierend auf dem differentiellen Wert bestimmt.

Gemäß einer solchen Ausführungsform kann der Schritt des Anlegens der elektrischen Spannung beinhalten, dass in einem ersten Schritt eine elektrische Spannung mit einem ersten Spannungsbetrag (1. Amplitude) angelegt wird, sodass die zweckgebundene Leiterbahnstruktur 13 das statischen magnetischen Feld 14' mit der bekannten Feldverteilung 14 erzeugt. Das erzeugte statische magnetische Feld 14' mit der bekannten Feldverteilung 14 kann dann mittels des Magnetfeldsensors 12 erfasst werden. In einem darauffolgenden zweiten Schritt kann eine elektrische Spannung mit einem zweiten Spannungsbetrag (2. Amplitude) angelegt werden, sodass die zweckgebundene Leiterbahnstruktur 13 ein zweites statisches magnetisches Feld mit einer ebenfalls bekannten Feldverteilung erzeugt. Der erste und der zweite Spannungsbetrag, das heißt die erste und die zweite Amplitude, sollten sich dabei unterscheiden. Das erzeugte zweite statische magnetische Feld kann dann ebenfalls mittels des Magnetfeldsensors 12 erfasst werden. Anschließend kann dann eine Differenz zwischen der Feldstärke des ersten statischen magnetischen Felds 14' und der Feldstärke des zweiten statischen magnetischen Felds bestimmt werden. Letztlich kann die Lage des Bauteils 11 relativ zu dem Substrat 10 bestimmt werden, und zwar basierend auf der Differenz zwischen dem statischen magnetischen Feld 14' und dem zweiten statischen magnetischen Feld.

Anstatt des Erzeugens des zweiten statischen magnetischen Felds mittels der zweckgebundenen Leiterbahnstruktur 13 kann auch eine zweite Leiterbahnstruktur 13' vorgesehen sein mittels derer das zweite statische magnetische Feld erzeugt werden kann.

In einem solchen Ausführungsbeispiel könnte das erfindungsgemäße Verfahren einen Schritt des Erzeugens von mindestens einer zweiten zweckgebundenen Leiterbahnstruktur 13' auf dem Substrat 10 zum Zwecke des Erzeugens eines zweiten statischen magnetischen Felds mit bekannter Feldverteilung aufweisen. Das erzeugte zweite statische magnetische Feld kann mittels des Magnetfeldsensors 12 erfasst werden. Die Lage des Bauteils 11 relativ zu dem Substrat 10 kann dann basierend auf der Erfassung des statischen magnetischen Felds 14' mit der bekannten Feldverteilung 14 und der Erfassung des zweiten statischen magnetischen Felds mit der bekannten Feldverteilung erfolgen. Auch hierbei kann wieder eine differenzielle Messung der jeweiligen Feldstärke der beiden statischen magnetischen Felder erfolgen.

Es kann ebenso denkbar sein, dass die elektrische Spannung zumindest einmal umgepolt wird. Das heißt die Spannung wird zumindest einmal wechselseitig angelegt, sodass der Strom zumindest einmal in die entgegengesetzte Richtung fließt und zusätzlich zu dem statischen magnetischen Feld 14' mit bekannter Feldverteilung 14 ein entgegengesetzt gerichtetes statischen magnetischen Feld mit bekannter Feldverteilung erzeugt. Auch hierbei kann eine differenzielle Messung der Feldstärken der beiden statischen magnetischen Felder erfolgen.

Gemäß einem solchen Ausführungsbeispiel kann der Schritt des Anlegens der elektrischen Spannung an die zweckgebundene Leiterbahnstruktur 13 beinhalten, dass die elektrische Spannung zumindest einmal wechselseitig angelegt wird, sodass der Strom zumindest einmal in die entgegengesetzte Richtung fließt und ein entgegengesetztes statisches magnetisches Feld mit bekannter Feldverteilung erzeugt. Das erzeugte entgegengesetzte statische magnetische Feld kann mittels des Magnetfeldsensors 12 erfasst werden, und eine Differenz zwischen dem erzeugten statischen magnetischen Feld 14' und dem erzeugten entgegengesetzten statischen magnetischen Feld kann bestimmt werden.

In anderen Worten kann mittels des Magnetfeldsensors 12 das erzeugte entgegengesetzte statische magnetische Feld gemessen werden, und anschließend kann eine Differenz zwischen dem erzeugten statischen magnetischen Feld 14' und dem erzeugten entgegengesetzten statischen magnetischen Feld bestimmt werden, wobei basierend auf dieser Differenz die Lage des Bauteils 11 relativ zu dem Substrat 10 bestimmt werden kann.

Das entgegengesetzte statischen magnetischen Feld kann dabei entweder mit derselben zweckgebundenen Leiterbahnstruktur 13 erzeugt werden, mit der auch das erste statischen magnetischen Feld 14' mit der bekannten Feldverteilung erzeugt wird, oder mit einer weiteren zusätzlichen zweckgebundenen Leiterbahnstruktur 13'.

Durch die oben genannten Beispiele von differenziellen Messungen wird es möglich, Störfelder und insbesondere homogene Störfelder, wie zum Beispiel das Erdmagnetfeld, zu bestimmen und zu kompensieren.

Eine Umpolung ist dabei nicht unbedingt erforderlich. Es ist jedoch anzumerken, dass das differentielle Signal weiterverarbeitet wird. Bei Wechselfeldern ist immer ein Wechselfeld vorhanden und diese Bedingung ist somit stets erfüllt

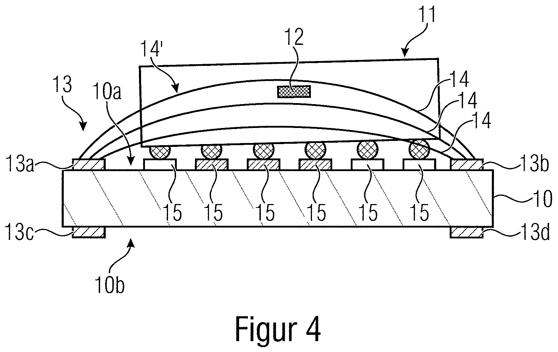

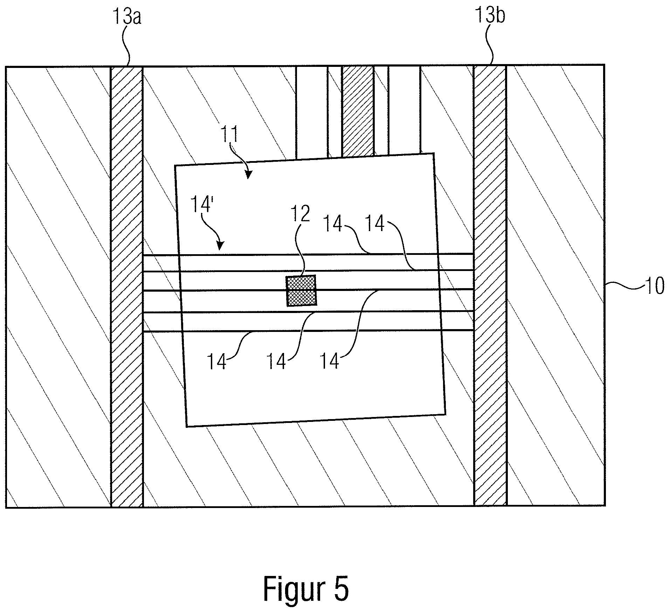

Die Figuren 4 und 5 zeigen eine nicht zur hierin beschriebenen Erfindung gehörigen Vorrichtung zur Lagebestimmung eines auf einem Substrat 10 angeordneten Bauteils 11. Allerdings wird hier die Lagebestimmung nicht mittels eines statischen magnetischen Felds sondern mittels eines elektrostatischen Felds durchgeführt. Anhand der Figuren 4 und 5 wird außerdem das entsprechende, aber ebenfalls nicht zur hierin beschriebenen Erfindung gehörige, Verfahren zur Lagebestimmung eines auf einem Substrat 10 angeordneten Bauteils 11 mittels eines elektrostatischen Felds beschrieben.

Dieses Beispiel entspricht im Wesentlichen dem mit Bezug auf die Figuren 2 und 3 diskutierten Ausführungsbeispiel, weshalb Elemente mit gleicher Funktion mit den gleichen Bezugszeichen versehen sind. Jedoch wird anstelle eines statischen magnetischen Felds ein elektrostatisches Feld betrachtet, und anstelle des Magnetfeldsensors 12 ist ein kapazitiver Sensor 12 vorgesehen.

An dem Substrat 10 ist ein Bauteil 11 angeordnet, dessen Lage relativ zu dem Substrat 10 bestimmt werden soll. In dem Bauteil 11 kann ein kapazitiver Sensor 12 integriert sein, sodass der kapazitive Sensor 12 selbst das Bauteil 11 darstellt, dessen Lage bestimmt werden soll. Alternativ kann der kapazitive Sensor 12 an dem Bauteil 11 angeordnet, oder zusammen mit dem Bauteil 11 in einem Package angeordnet sein. Dann kann anhand der Lagebestimmung des kapazitiven Sensors 12 auf die Lage des Bauteils 11 relativ zu dem Substrat 10 rückgeschlossen werden.

Auf dem Substrat 10 ist ferner eine zweckgebundene Leiterbahnstruktur 13 vorgesehen. Die zweckgebundene Leiterbahnstruktur 13 weist in diesem nicht limitierenden Beispiel zwei Leiterbahnen 13a, 13b auf, die derart zueinander angeordnet sind, dass sich beim Anlegen einer elektrischen Spannung ein elektrostatisches Feld 14 zwischen den mindestens zwei Leiterbahnen 13a, 13b ausbildet.

Alternativ kann die zweckgebundene Leiterbahnstruktur 13 lediglich eine Leiterbahn 13a aufweisen, wobei sich zwischen dieser einen Leiterbahn 13a und dem kapazitiven Sensor 12 ein elektrostatisches Feld ausbilden kann.

Mindestens eine der zwei beispielhaft abgebildeten Leiterbahnen 13a, 13b kann auf derselben Seite 10a des Substrats 10 angeordnet sein wie das Bauteil 11, dessen Lage relativ zu dem Substrat 10 bestimmt werden soll. Alternativ oder zusätzlich kann mindestens eine weitere Leiterbahn 13c, 13d auf der dem Bauteil 11 gegenüberliegenden Seite 10b des Substrats 10 angeordnet sein.

Zwischen den beiden Leiterbahnen 13a, 13b bildet sich, beim Anlegen einer elektrischen Spannung, ein elektrostatisches Feld 14' zwischen den beiden Leiterbahnen 13a, 13b aus. Das elektrostatische Feld 14' weist mehrere Feldlinien 14 auf, die zusammen die Feldverteilung des elektrostatischen Felds 14' darstellen.

Das Bauteil 11 ist vorteilhafter Weise räumlich zwischen den mindestens zwei Leiterbahnen 13a, 13b angeordnet. Somit verlaufen die Feldlinien 14, zumindest teilweise, durch das Bauteil 11, und insbesondere durch den kapazitiven Sensor 12 hindurch. Da die Feldverteilung des elektrostatischen Felds 14' bekannt ist, kann hierüber ein Rückschluss auf die räumliche Lage des Bauteils 11, bzw. des kapazitiven Sensors 12, relativ zu dem Substrat 10 erfolgen.

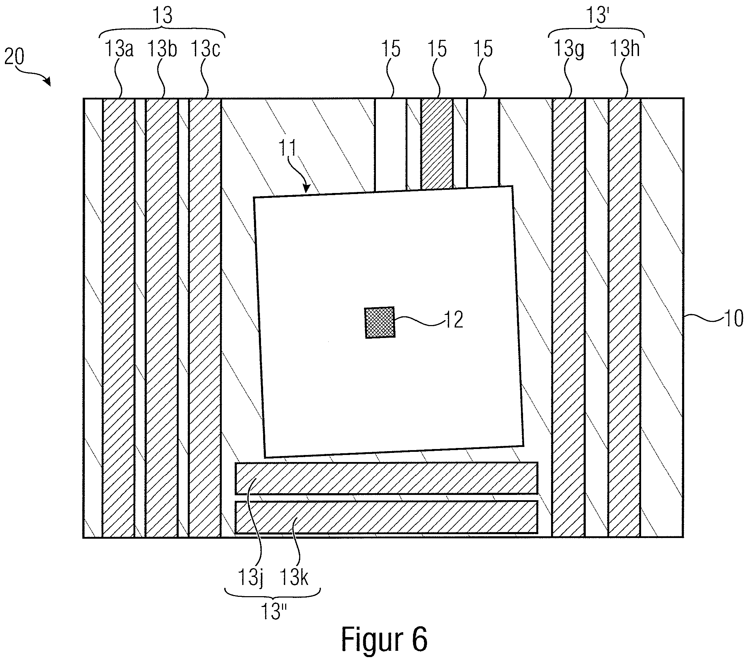

Figur 6 zeigt ein weiteres denkbares Ausführungsbeispiel, das sowohl für statische magnetische Felder als auch für elektrostatische Felder, und somit für Magnetfeldsensoren 12 sowie für kapazitive Sensoren 12 gilt.

Wie in Figur 6 zu sehen ist, können weitere zweckgebundene Leiterbahnstrukturen 13 auf dem Substrat 10 vorgesehen sein. Genauer gesagt ist auf dem Substrat 10 die oben beschriebene zweckgebundene Leiterbahnstruktur 13 angeordnet, die mindestens eine Leiterbahn 13a, 13b, 13c aufweist. Ferner kann mindestens eine weitere zweckgebundene Leiterbahnstruktur 13' auf dem Substrat 10 vorgesehen sein, die ebenfalls mindestens eine Leiterbahn 13g, 13h aufweist. Ferner kann eine weitere zweckgebundene Leiterbahnstruktur 13" auf dem Substrat 10 vorgesehen sein, die ihrerseits mindestens eine Leiterbahn 13j, 13k aufweist.

Wie in Figur 6 außerdem zu erkennen ist, kann die mindestens eine weitere zweckgebundene Leiterbahnstruktur 13' beispielsweise auf einer der ersten zweckgebundenen Leiterbahnstruktur 13 gegenüberliegenden Seite des Magnetfeldsensors 12 bzw. des kapazitiven Sensors 12 angeordnet sein. Alternativ oder zusätzlich kann die mindestens eine weitere zweckgebundene Leiterbahnstruktur 13" entlang einer (im Vergleich zur ersten zweckgebundenen Leiterbahnstruktur 13) anderen Seite des Magnetfeldsensors 12 bzw. des kapazitiven Sensors 12 angeordnet sein.

Wie außerdem in Figur 6 zu erkennen ist, kann die mindestens eine weitere zweckgebundene Leiterbahnstruktur 13' mindestens eine Leiterbahn 13g, 13h aufweisen, die parallel zu der mindestens einen Leiterbahn 13a, 13b, 13c der ersten zweckgebundenen Leiterbahnstruktur 13 verläuft. Alternativ oder zusätzlich kann die mindestens eine weitere zweckgebundene Leiterbahnstruktur 13" mindestens eine Leiterbahn 13j, 13k aufweisen, die schräg, und insbesondere orthogonal, zu der mindestens einen Leiterbahn 13a, 13b, 13c der ersten zweckgebundenen Leiterbahnstruktur 13 verläuft.

An diese mindestens eine weitere zweckgebundenen Leiterbahnstruktur 13', 13" kann nun ebenfalls eine Spannung angelegt werden, sodass der durch die Leiterbahnen 13g, 13h, 13j, 13k der mindestens einen weiteren zweckgebundenen Leiterbahnstruktur 13', 13" fließende Strom mindestens ein weiteres statisches magnetisches bzw. elektrostatisches Feld erzeugt. Vorteilhafter Weise ist die Feldverteilung des mindestens einen weiteren statischen magnetischen bzw. elektrostatischen Feld ebenfalls bekannt.

Gemäß diesem Ausführungsbeispiel können also mehrere Leiterbahnstrukturen 13, 13', 13" zur Erzeugung von verschiedenen statischen magnetischen Feldern verwendet werden, um beispielsweise mehrere Freiheitsgrade der Lage des Bauteils 11 zu bestimmen.

Richtig durchgeführt ist es mit einer solchen Mehrfachmessung zudem möglich, sowohl die Dicke als auch die Ausdehnung der Leiterbahnstrukturen 13, 13', 13" auf der Leiterplatte 10 zu messen, was eine Berücksichtigung dieser weiteren Fertigungstoleranzen ermöglicht.

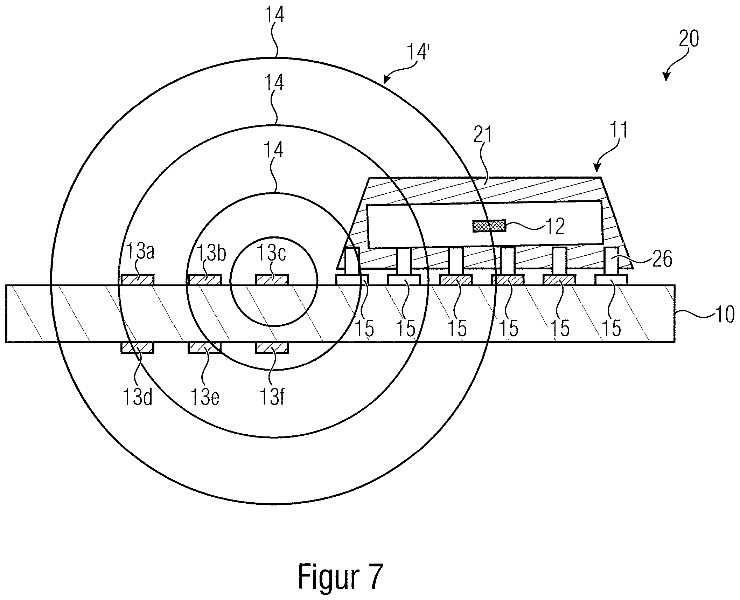

Figur 7 zeigt ein weiteres Ausführungsbeispiel einer erfindungsgemäßen Vorrichtung 20. Dieses Ausführungsbeispiel entspricht im Wesentlichen dem mit Bezug auf die Figuren 2, 3 und 6 diskutierten Ausführungsbeispielen, weshalb Elemente mit gleicher Funktion mit den gleichen Bezugszeichen versehen sind. Dieses in Figur 7 gezeigte Ausführungsbeispiel unterscheidet sich jedoch zu den in den Figuren 2 bis 6 gezeigten Ausführungsbeispielen unter anderem dadurch, dass der eingangs erwähnte Magnetfeldsensor 12, bzw. der kapazitive Sensor 12, zusammen mit dem Bauteil 11 in einem Package 21 angeordnet ist.

Lediglich beispielhaft wird nachfolgend ein Magnetfeldsensor 12 als ein Beispiel für eine Vorrichtung 12 zum Erfassen eines statischen magnetischen Felds beschrieben. Die nachfolgende Beschreibung gilt aber gleichsam ebenso für ein elektrostatisches Feld und einen kapazitiven Sensor 12 zum Erfassen des elektrostatischen Felds, wobei dies nicht Gegenstand der hierin beschriebenen Erfindung ist.

Wie in Figur 7 zu sehen ist, kann der Magnetfeldsensor 12 hier in dem Bauteil 11, dessen Lage relativ zu dem Substrat 10 unter Zuhilfenahme des Magnetfeldsensors 12 bestimmt werden soll, angeordnet bzw. integriert sein. Dieses Bauteil 11 kann wiederum in einem Package 21 angeordnet sein.

Mit dem erfindungsgemäßen Konzept lässt sich die Lage des Magnetfeldsensors 12, bzw. des kapazitiven Sensors 12, und somit des Bauteils 11 relativ zu der Leiterbahnstruktur 13 und relativ zu dem Substrat 10 bestimmen. Dies kann auch dann geschehen, wenn das Bauteil 11 innerhalb eines Packages 21 verkippt bzw. verdreht angeordnet sein sollte. Das heißt, es spielt lediglich eine untergeordnete Rolle wie das Package 21 selbst in Relation zu dem Substrat 10 angeordnet ist, da in der Regel lediglich die relative Lage des Bauteils 11 zu dem Substrat 10 von Interesse ist.

Außerdem ist hier in Figur 7 eine weitere Möglichkeit der Befestigung des Bauteils 11 an dem Substrat 10 gezeigt. Anstatt der zuvor genannten Lotkugeln 16 sind hier Pins 26 abgebildet. Auch bei der Anordnung des Bauteils 11 auf dem Substrat 10 mittels Pins 26 kann es zu den zuvor erwähnten Verkippungen und/oder Verdrehungen des Bauteils 11 relativ zu dem Substrat 10 kommen.

Wie in Figur 7 zu erkennen ist, kann beispielsweise der Magnetfeldsensor 12 innerhalb des Packages 21 verkippt sein. Das heißt, obwohl das Package 21 zentriert auf dem Substrat 10 aufliegt, ist der Magnetfeldsensor 12 aufgrund seiner Verkippung innerhalb des Packages 21 auch relativ zum Substrat 10 verkippt, was zu ungenauen Messungen führen kann. Da das Package 21 in der Regel undurchsichtig ist, kann die verkippte Ausrichtung des Magnetfeldsensors 12 innerhalb des Packages 21 mit optischen Mitteln nicht erkannt werden. Mit der erfindungsgemäßen Vorrichtung 20, beziehungsweise mit dem erfindungsgemäßen Verfahren ist es hingegen möglich, diese Verkippung auf einfache Weise festzustellen.

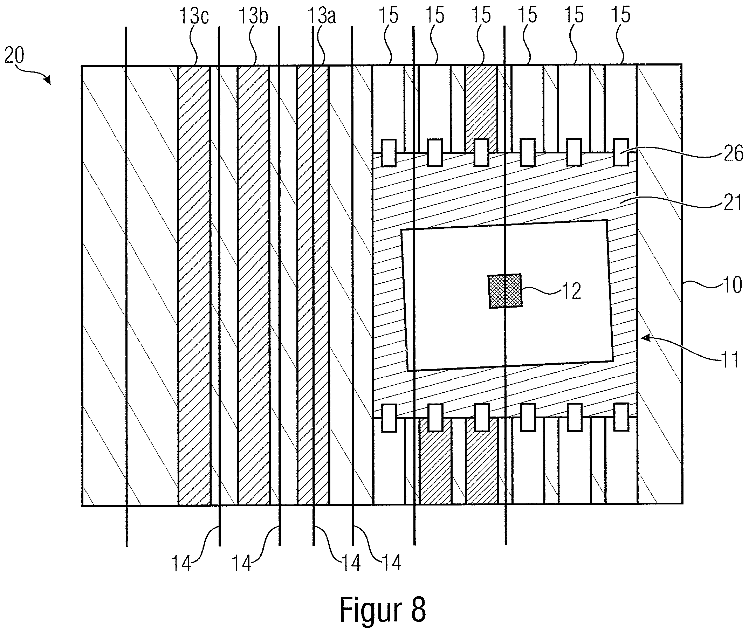

Figur 8 zeigt eine Draufsicht auf das Ausführungsbeispiel mit Chip-Package 21. Dieses Ausführungsbeispiel entspricht im Wesentlichen dem mit Bezug auf die Figuren 3 diskutierten Ausführungsbeispiel, weshalb Elemente mit gleicher Funktion mit den gleichen Bezugszeichen versehen sind.

Auch hier ist zu erkennen, dass der Magnetfeldsensor 12 innerhalb des Packages 21 verdreht sein kann. Das heißt, obwohl das Package 21 zentriert auf dem Substrat 10 aufliegt, ist der Magnetfeldsensor 12 aufgrund seiner Verdrehung innerhalb des Packages 21 auch relativ zum Substrat 10 verdreht, was zu ungenauen Messungen führen kann. Da das Package 21 in der Regel undurchsichtig ist, kann die verdrehte Ausrichtung des Magnetfeldsensors 12 innerhalb des Packages 21 mit optischen Mitteln nicht erkannt werden. Mit der erfindungsgemäßen Vorrichtung 20, beziehungsweise mit dem erfindungsgemäßen Verfahren ist es hingegen möglich, diese Verdrehung auf einfache Weise festzustellen.

Bezüglich der weiteren funktionellen sowie strukturellen Beschreibung des in den Figuren 7 und 8 gezeigten Ausführungsbeispiels wird auf die obige Diskussion zu dem in den Figuren 2, 3 und 6 gezeigten Ausführungsbeispielen verwiesen.

Mit hinreichend kalibrierten Magnetfeldsensoren 12 lässt sich also mittels des erfindungsgemäßen Verfahrens die Lage der Magnetfeldsensoren 12 relativ zu den Leiterbahnstrukturen 13, 13', 13" und damit relativ zur Leiterplatte, d.h. zum Substrat 10, selbst rekonstruieren. Die Lage der Platine, bzw. des Substrats 10, in einer späteren Anwendung kann dann optisch oder mechanisch referenziert werden. Dieses Messprinzip kann auch elektrostatisch oder elektromagnetisch erfolgen, wenn anstelle von Magnetfeldsensoren 12 geeignete kapazitive Sensoren oder Antennen verwendet werden.

Nachfolgend soll die Erfindung nochmals in anderen Worten zusammengefasst werden, wobei anstelle des erfindungsgemäßen Magnetfeldsensors 12 auch eine Antenne oder ein kapazitiver Sensor, und anstelle des statischen magnetischen Felds (bzw. des Magnetfelds) ein elektrostatisches Feld vorgesehen sein kann:
Um die Position eines Bauteils 11, wie zum Beispiel eines Magnetfeldsensors 12, im Raum mittels des erfindungsgemäßen Verfahrens bestimmen zu können, ist es vorteilhaft, wenn erfindungsgemäße Magnetfeldsensoren 12 mit ausreichender Genauigkeit kalibriert sind und einen möglichst geringen Messfehler aufweisen. Durch exakte Messung des Feldvektors eines extern angelegten statischen Magnetfeldes 14' lässt sich so auf die Position des Magnetfeldsensors 12 relativ zur Magnetfeldquelle (zweckgebundene Leiterbahnstruktur 13, 13', 13") schließen.

Dabei ist es vorteilhaft, wenn die Form des erzeugten Magnetfeldes 14' sehr genau bekannt ist, um einen Rückschluss zuzulassen. Dies kann über diverse Ansätze berechnet werden, wie beispielsweise eine inverse Lösung des Satzes von Biot-Savart oder über eine Modellierung des Magnetfeldes 14' und die Optimierung des Messwertes an dieses Modell mittels geeigneter Algorithmen.

Das statische Magnetfeld 14' zur Bestimmung der Lage des Bauteils 11 kann erfindungsgemäß beispielsweise mittels einer in dem Substrat 10, zum Beispiel einer Leiterplatte, integrierten zweckgebundenen Leiterbahnstruktur 13', 13', 13" generiert werden, welche sich bestromen lässt. Die zweckgebundene Leiterbahnstruktur 13', 13', 13" kann eine oder mehrere Leiterbahnen 13a-13k aufweisen, die beispielsweise als einfache Geraden oder auch als Spulenstrukturen mit mehreren parallelen Wicklungen ausgestaltet sein können.

Aufgrund der Herstellungsweise von Leiterplatten mittels optischer Belichtung kann eine sehr hohe Fertigungsgenauigkeit erreicht werden, welche den Anforderungen an die Kenntnis der Form des Magnetfeldes 14' genügen. Hierbei ist es von Vorteil, wenn der Strom, der ein Magnetfeld 14' erzeugt, nicht nur an- und abgestellt werden kann, sondern bei entgegengesetzter Stromrichtung ein entgegengesetztes Magnetfeld erzeugt, wodurch eine differenzielle Messung zur Kompensierung von homogenen Störfeldern (z.B. das Erdmagnetfeld) möglich ist.

Befinden sich nun einer oder mehrere vektorielle Magnetfeldsensoren 12 in messbarer Nähe der Magnetfeldquelle 13', 13', 13", lässt sich deren Lage relativ zu der zweckgebundenen Leiterbahnstruktur 13', 13', 13" durch das magnetische Vektorfeld eindeutig bestimmen. Durch die hohe Fertigungsgenauigkeit der Leiterplatte 10 lässt sich somit ein eindeutiger Rückschluss auf die Lage des Magnetfeldsensors 12 relativ zur zweckgebundenen Leiterbahnstruktur 13', 13', 13" beziehungsweise relativ zur Leiterplatte 10 ziehen.

Hierzu kann es vorteilhaft sein, mehrere zweckgebundene Leiterbahnstrukturen 13', 13', 13" zur Erzeugung von verschiedenen Magnetfeldern zu verwenden, um dementsprechend mehrere Freiheitsgrade der Lage des Magnetfeldsensors 12 zu bestimmen. Richtig durchgeführt ist es mit einer solchen Mehrfachmessung zudem möglich, sowohl die Dicke als auch die Ausdehnung der zweckgebundenen Leiterbahnstruktur 13', 13', 13" auf der Leiterplatte 10 zu messen, was eine Berücksichtigung dieser weiteren Fertigungstoleranzen ermöglicht.

Mit kalibrierten und hinreichend genau messenden Magnetfeldsensoren 12 lässt sich so die Lage der Magnetfeldsensoren 12 relativ zu der zweckgebundenen Leiterbahnstruktur 13', 13', 13" und damit zur Leiterplatte 10 selbst rekonstruieren. Die Lage der Platine 10 in einer späteren Anwendung kann dann optisch oder mechanisch referenziert werden. Dieses Messprinzip kann auch elektrostatisch oder elektromagnetisch erfolgen, wenn anstelle von Magnetfeldsensoren 12 geeignete kapazitive Sensoren oder Antennen verwendet werden.

Integrierte Magnetfeldsensoren 12 lassen sich mittlerweile durch geeignete Methoden magnetisch kalibrieren, ohne dass Sie in ein externes Referenzfeld gebracht werden müssen. Mittels einer erfindungsgemäß in der Leiterplatte 10 integrierten zweckgebundenen Leiterbahnstruktur 13', 13', 13" zur Felderzeugung ist es nun möglich, auch die letzten unbekannten Parameter für die Position des auf der Leiterplatte 10 angeordneten Bauteils 11 zu bestimmen, ohne dass ein bekanntes externes Magnetfeld angelegt werden muss (z.B. durch 3D Helmholtzspule) oder andere aufwändige Verfahren angewendet werden müssen.

Dadurch entfällt ein kostspieliger magnetischer oder optischer Endtest von Bauteilen und sowohl magnetische Einzelsensoren als auch Sensormodule aus mehreren Magnetfeldsensoren lassen sich so ohne großen Aufwand voll kalibrieren. Zudem ist es möglich, Sensoren oder Sensormodule nachträglich während des Betriebs nachzukalibrieren, um Alterungseffekte von Sensoren und Leiterplatte zu erkennen und zu kompensieren.

Darüber hinaus lässt sich die Fertigungsqualität des PCB 10 beurteilen, indem die Ausdehnung der zweckgebundenen Leiterbahnstruktur 13', 13', 13" gemessen werden kann (verursacht durch Skalierungsfehler bei optischer Belichtung) als auch die Dicke der Leiterplatte 10 bzw. die Struktur des Lagenaufbaus bestimmt werden kann, wenn auf allen Lagen der Leiterplatte 10 derartige zweckgebundene Leiterbahnstrukturen 13', 13', 13" vorhanden sind. Sobald die exakte Sensorposition relativ zur zweckgebundenen Leiterbahnstruktur 13', 13', 13" und damit zum restlichen PCB 10 bekannt ist, kann der Ort der Magnetfeldmessung eindeutig bestimmt werden, was für Sensorik-Anwendungen essentiell ist.

Anstelle von zweckgebundenen Leiterbahnstrukturen 13', 13', 13" könnten andere Bauteile zur Erzeugung eines Magnetfeldes verwendet werden. Durch diskreten Aufbau einer solchen Anordnung mit beispielweise Drähten oder Spulen kann ein vergleichbares System aufgebaut werden. Sobald die Magnetfeldquelle aber nicht die Leiterplatte 10 selbst ist, verliert man den Vorteil der hohen Fertigungsgenauigkeit der Leiterplatte 10 und muss die Bauteilposition auf eine andere Weise feststellen.

Sobald sich auf einer Leiterplatte 10, auf der sich Magnetfeldsensoren 12 befinden, zusätzlich Leiterbahnstrukturen 13', 13', 13" vorhanden sind, die keinem anderen Zweck dienen, als elektrischen Strom zur Erzeugung eines Magnetfeldes 14' zu führen (z.B. extern eingespeist oder durch interne Stromquelle), ist davon auszugehen, dass sie zur erfindungsgemäßen magnetischen Kalibrierung verwendet werden. Zu Gunsten eines hohen Signal-Rausch-Verhältnisses ist es vorteilhaft, wenn sich die Leiterbahnstruktur 13', 13', 13" während der Messung so nahe wie möglich an den Magnetfeldsensoren 12 befindet. Außerdem wäre es denkbar, die Leiterbahnstrukturen 13', 13', 13" im Lagenaufbau der Platine 10 zu verbergen.

Das Anwendungsgebiet wäre hauptsächlich in der Magnetfeldsensorik zu finden. So könnte das Prinzip sowohl bei der reinen Magnetfeldmessung als auch bei weiterführenden Anwendungen wie Positions- oder Inertialsensorik zum Einsatz kommen. Gerade auch Anwendungen, bei denen mehrere Magnetfeldsensoren 12 genutzt werden, können durch das erfindungsgemäße Prinzip verbessert werden, wie beispielsweise bei Magnetfeldkameras und anderen magnetischen Prüfmitteln. Außerdem wäre es denkbar, dass ein oder mehrere magnetische Sensoren 12 als "Lagesensoren" mit im Halbleitermaterial (z.B. Silizium) von anderen Halbleiterschaltungen integriert werden, um die Lage des Halbleitermaterials relativ zur Leiterplatte 10 zu messen. Beispiele hierfür wären etwa Bildsensoren oder Empfängerschaltungen zur drahtlosen Kommunikation.

Alle Aspekte, die mit Bezug auf ein statisches magnetisches Feld 14' sowie auf einen Magnetfeldsensor 12 hierin beschrieben sind, gelten gleichsam auch für ein elektrostatisches Feld 14' sowie für einen kapazitiven Sensor 12.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Einige oder alle der Verfahrensschritte können durch einen Hardware-Apparat (oder unter Verwendung eines Hardware-Apparats), wie zum Beispiel einen Mikroprozessor, einen programmierbaren Computer oder einer elektronischen Schaltung durchgeführt werden. Bei einigen Ausführungsbeispielen können einige oder mehrere der wichtigsten Verfahrensschritte durch einen solchen Apparat ausgeführt werden.

Je nach bestimmten Implementierungsanforderungen können Ausführungsbeispiele der Erfindung in Hardware oder zumindest teilweise in Hardware oder zumindest teilweise in Software implementiert sein. Die Implementierung kann unter Verwendung eines digitalen Speichermediums, beispielsweise einer Floppy-Disk, einer DVD, einer BluRay Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein.

Die folgenden Ausführungsbeispiele sind nicht als vollständige Ausführungsbeispiele gemäß der vorliegenden Erfindung zu verstehen, sondern beschreiben lediglich Möglichkeiten, zur Ausführung bestimmter Schritte des erfindungsgemäßen Verfahrens. Das erfindungsgemäße Verfahren als solches, ist ausschließlich durch Anspruch 1 definiert. Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft.

Der Programmcode kann beispielsweise auch auf einem maschinenlesbaren Träger gespeichert sein.

Andere Ausführungsbeispiele umfassen das Computerprogramm zum Durchführen eines der hierin beschriebenen Verfahren, wobei das Computerprogramm auf einem maschinen-lesbaren Träger gespeichert ist. Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft.

Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist. Der Datenträger oder das digitale Speichermedium oder das computerlesbare Medium sind typischerweise greifbar und/oder nicht flüchtig.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Ein weiteres Ausführungsbeispiel gemäß der Erfindung umfasst eine Vorrichtung oder ein System, die bzw. das ausgelegt ist, um ein Computerprogramm zur Durchführung zumindest eines der hierin beschriebenen Verfahren zu einem Empfänger zu übertragen. Die Übertragung kann beispielsweise elektronisch oder optisch erfolgen. Der Empfänger kann beispielsweise ein Computer, ein Mobilgerät, ein Speichergerät oder eine ähnliche Vorrichtung sein. Die Vorrichtung oder das System kann beispielsweise einen Datei-Server zur Übertragung des Computerprogramms zu dem Empfänger umfassen.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Verfahren zur Lagebestimmung eines auf einem Substrat (10) angeordneten Bauteils (11), wobei das Verfahren die folgenden Schritte aufweist:
Bereitstellen eines Substrats (10) mit mindestens einem daran angeordneten Magnetfeldsensor (12) zum Erfassen eines statischen magnetischen Felds (14') und zum Bestimmen der räumlichen Orientierung des Bauteils (11) relativ zu dem Substrat (10),
Erzeugen einer zweckgebundenen Leiterbahnstruktur (13) auf dem Substrat (10), wobei die zweckgebundene Leiterbahnstruktur (13) zum Zwecke des Erzeugens eines statischen magnetischen Felds (14') mit bekannter Feldverteilung (14) vorgesehen ist,
Anlegen einer elektrischen Spannung an die zweckgebundene Leiterbahnstruktur (13), sodass die zweckgebundene Leiterbahnstruktur (13) das statische magnetische Feld (14') mit der bekannten Feldverteilung (14) erzeugt,
Erfassen des erzeugten statischen magnetischen Felds (14') mit der bekannten Feldverteilung (14) mittels des Magnetfeldsensors (12) und Bestimmen der räumlichen Orientierung des Bauteils (11) relativ zu dem Substrat (10) basierend auf der Erfassung des statischen magnetischen Felds (14') mit der bekannten Feldverteilung (14).

2. Verfahren nach Anspruch 1, wobei der Schritt des Anlegens der elektrischen Spannung beinhaltet, dass eine Gleichspannung angelegt wird.

3. Verfahren nach einem der Ansprüche 1 oder 2, wobei die an die zweckgebundene Leiterbahnstruktur (13) angelegte elektrische Spannung größer ist als eine zur Energieversorgung von auf dem Substrat (10) angeordneten Bauteilen verwendete elektrische Spannung.

4. Verfahren nach einem der Ansprüche 1 bis 3, wobei der Schritt des Erzeugens der zweckgebundenen Leiterbahnstruktur (13) auf dem Substrat (10) beinhaltet, dass die zweckgebundene Leiterbahnstruktur (13) derart erzeugt wird, dass sie eine einzelne Leiterbahn (13a) aufweist.

5. Verfahren nach einem der Ansprüche 1 bis 3, wobei der Schritt des Erzeugens der zweckgebundenen Leiterbahnstruktur (13) auf dem Substrat (10) beinhaltet, dass die zweckgebundene Leiterbahnstruktur (13) derart erzeugt wird, dass sie zwei oder mehr Leiterbahnen (13a, 13b, 13c) aufweist.

6. Verfahren nach einem der Ansprüche 4 oder 5, wobei der Schritt des Erzeugens der zweckgebundenen Leiterbahnstruktur (13) auf dem Substrat (10) beinhaltet, dass mindestens eine Leiterbahn (13a) der zweckgebundenen Leiterbahnstruktur (13) derart erzeugt wird, dass sie als eine auf dem Substrat (10) verlaufende Gerade ausgestaltet ist.

7. Verfahren nach einem der Ansprüche 1 bis 6, wobei der Schritt des Erzeugens der zweckgebundenen Leiterbahnstruktur (13) auf dem Substrat (10) beinhaltet, dass die zweckgebundene Leiterbahnstruktur (13) derart erzeugt wird, dass sie als eine Spulenstruktur mit mehreren parallelen Wicklungen ausgestaltet ist.

8. Verfahren nach einem der Ansprüche 1 bis 7, wobei der Schritt des Erzeugens der zweckgebundenen Leiterbahnstruktur (13) auf dem Substrat (10) beinhaltet, dass die zweckgebundene Leiterbahnstruktur (13) derart erzeugt wird, dass sie unmittelbar neben dem Magnetfeldsensor (12) entlang verläuft.

9. Verfahren nach einem der Ansprüche 1 bis 8, wobei der Schritt des Erzeugens der zweckgebundenen Leiterbahnstruktur (13) auf dem Substrat (10) beinhaltet, dass die zweckgebundene Leiterbahnstruktur (13) mittels Fotolithografie in das Substrat (10) strukturiert wird.

10. Verfahren nach einem der Ansprüche 1 bis 9, wobei der Schritt des Anlegens der elektrischen Spannung beinhaltet, dass in einem ersten Schritt eine elektrische Spannung mit einem ersten Spannungsbetrag angelegt wird, sodass die zweckgebundene Leiterbahnstruktur (13) das magnetische Feld (14') mit der bekannten Feldverteilung (14) erzeugt, und dass in einem darauffolgenden zweiten Schritt eine elektrische Spannung mit einem zweiten Spannungsbetrag angelegt wird, sodass die zweckgebundene Leiterbahnstruktur (13) ein weiteres magnetisches Feld mit einer ebenfalls bekannten Feldverteilung erzeugt, Erfassen des erzeugten weiteren magnetischen Felds mittels des Magnetfeldsensors(12), und Bestimmen der räumlichen Orientierung des Bauteils (11) relativ zu dem Substrat (10) basierend auf einer Ermittlung der Differenz zwischen dem magnetischen Feld (14') und dem weiteren magnetischen Feld.

11. Verfahren nach einem der Ansprüche 1 bis 10, aufweisend einen Schritt des Erzeugens von mindestens einer zweiten zweckgebundenen Leiterbahnstruktur (13') auf dem Substrat (10) zum Zwecke des Erzeugens eines zweiten magnetischen Felds mit bekannter Feldverteilung, Erfassen des erzeugten zweiten magnetischen Felds mittels dem Magnetfeldsensor (12), und Bestimmen der räumlichen Orientierung des Bauteils (11) relativ zu dem Substrat (10) basierend auf der Erfassung des magnetischen Felds (14') mit der bekannten Feldverteilung (14) und der Erfassung des zweiten magnetischen Felds mit der bekannten Feldverteilung.

12. Verfahren nach einem der Ansprüche 1 bis 11, wobei der Schritt des Anlegens der elektrischen Spannung an die zweckgebundene Leiterbahnstruktur (13) beinhaltet, dass die elektrische Spannung zumindest einmal wechselseitig angelegt wird, sodass der Strom zumindest einmal in die entgegengesetzte Richtung fließt und ein entgegengesetztes magnetisches Feld mit bekannter Feldverteilung erzeugt, Erfassen des erzeugten entgegengesetzten magnetischen Felds mittels dem Magnetfeldsensor (12), und Ermitteln einer Differenz zwischen dem erzeugten magnetischen Feld (14') und dem erzeugten entgegengesetzten magnetischen Feld.

13. Verfahren nach einem der Ansprüche 1 bis 12, wobei der Schritt des Erzeugens der zweckgebundenen Leiterbahnstruktur (13) auf dem Substrat (10) beinhaltet, dass die zweckgebundene Leiterbahnstruktur (13) auf derselben Seite (10a) des Substrats (10) erzeugt wird, auf der auch der Magnetfeldsensor (12) angeordnet ist.

14. Verfahren nach einem der Ansprüche 1 bis 12, wobei der Schritt des Erzeugens der zweckgebundenen Leiterbahnstruktur (13) auf dem Substrat (10) beinhaltet, dass die zweckgebundene Leiterbahnstruktur (13) auf der dem Magnetfeldsensor (12) gegenüberliegenden Seite (10b) des Substrats (10) erzeugt wird.

15. Verfahren nach einem der Ansprüche 1 bis 12, wobei der Schritt des Erzeugens der zweckgebundenen Leiterbahnstruktur (13) auf dem Substrat (10) beinhaltet, dass ein erster Abschnitt (13a, 13b, 13c) der zweckgebundenen Leiterbahnstruktur (13) auf derselben Seite (10a) des Substrats (10) erzeugt wird, auf der auch der Magnetfeldsensor (12) angeordnet ist, und dass ein zweiter Abschnitt (13d, 13e, 13f) der zweckgebundenen Leiterbahnstruktur (13) auf der dem Magnetfeldsensor (12) gegenüberliegenden Seite (10b) des Substrats (10) erzeugt wird.

16. Verfahren nach einem der Ansprüche 1 bis 15, wobei der Schritt des Erzeugens der zweckgebundenen Leiterbahnstruktur (13) auf dem Substrat (10) beinhaltet, dass die zweckgebundene Leiterbahnstruktur (13) als eine in das Substrat (10) integrierte vergrabene Leiterbahnstruktur ausgebildet wird.

17. Vorrichtung (20) zur Lagebestimmung eines auf einem Substrat (10) angeordneten Bauteils (11), wobei die Vorrichtung (20) aufweist:
ein Substrat (10) mit mindestens einem daran angeordneten Magnetfeldsensor (12) zum Erfassen eines statischen magnetischen Felds (14') und zum Bestimmen der räumlichen Orientierung des Bauteils (11) relativ zu dem Substrat (10),
eine auf dem Substrat (10) ausgebildete zweckgebundene Leiterbahnstruktur (13), wobei die zweckgebundene Leiterbahnstruktur (13) zum Zwecke des Erzeugens eines statischen magnetischen Felds (14') mit bekannter Feldverteilung (14) vorgesehen ist,
wobei die zweckgebundene Leiterbahnstruktur (13) ausgestaltet ist, um beim Anlegen einer elektrischen Spannung das statische magnetische Feld (14') mit der bekannten Feldverteilung (14) zu erzeugen, und
eine Auswertevorrichtung, die ausgestaltet ist, um das erzeugte statische magnetische Feld (14') mittels des Magnetfeldsensors (12) zu erfassen und die räumliche Orientierung des Bauteils (11) relativ zu dem Substrat (10) basierend auf der Erfassung des statischen magnetischen Felds (14') mit bekannter Feldverteilung (14) zu bestimmen.

## Claims

1. Method of positioning a component (11) arranged on a substrate (10), the method comprising:
providing a substrate (10) having arranged thereat at least one magnetic field sensor (12) for sensing a static magnetic field (14') and for determining the spatial orientation of the component (11) in relation to the substrate (10),
generating a dedicated conductive-trace structure (13) on the substrate (10), said dedicated conductive-trace structure (13) being provided for the purpose of generating a static magnetic field (14') having a known field distribution (14),
applying an electric voltage to the dedicated conductive-trace structure (13), so that the dedicated conductive-trace structure (13) generates the static magnetic field (14') having the known field distribution (14),
sensing the generated static magnetic field (14') having the known field distribution (14) by means of the magnetic field sensor (12), and determining the spatial orientation of the component (11) in relation to the substrate (10) on the basis of said sensing of the static magnetic field (14') having the known field distribution (14).

2. Method as claimed in claim 1, wherein applying the electric voltage comprises applying a DC voltage.

3. Method as claimed in claim 1 or 2, wherein the electric voltage applied to the dedicated conductive-trace structure (13) is higher than an electric voltage used for supplying components arranged on the substrate (10) with energy.

4. Method as claimed in any of claims 1 to 3, wherein the step of producing the dedicated conductive-trace structure (13) on the substrate (10) includes producing the dedicated conductive-trace structure (13) such that it comprises one single conductive trace (13a).

5. Method as claimed in any of claims 1 to 3, wherein the step of producing the dedicated conductive-trace structure (13) on the substrate (10) includes producing the dedicated conductive-trace structure (13) such that it comprises two or more conductive traces (13a, 13b, 13c).

6. Method as claimed in any of claims 4 or 5, wherein the step of producing the dedicated conductive-trace structure (13) on the substrate (10) includes at least one conductive trace (13a) of the dedicated conductive-trace structure (13) being produced to be configured as a straight line extending on the substrate (10).

7. Method as claimed in any of claims 1 to 6, wherein the step of producing the dedicated conductive-trace structure (13) on the substrate (10) includes producing the dedicated conductive-trace structure (13) to be configured as a coil structure having several parallel windings.

8. Method as claimed in any of claims 1 to 7, wherein the step of producing the dedicated conductive-trace structure (13) on the substrate (10) includes producing the dedicated conductive-trace structure (13) to extend directly next to and along the magnetic field sensor (12).

9. Method as claimed in any of claims 1 to 8, wherein the step of producing the dedicated conductive-trace structure (13) on the substrate (10) includes structuring the dedicated conductive-trace structure (13) into the substrate (10) by means of photolithography.

10. Method as claimed in any of claims 1 to 9, wherein the step of applying the electric voltage includes applying an electric voltage having a first amount of voltage in a first step, so that the dedicated conductive-trace structure (13) generates the magnetic field (14') having the known field distribution (14), and includes applying an electric voltage having a second amount of voltage in a subsequent second step, so that the dedicated conductive-trace structure (13) generates a further magnetic field having a field distribution that is also known, sensing the generated further magnetic field by means of the magnetic field sensor (12), and determining the spatial orientation of the component (11) in relation to the substrate (10) on the basis of determining the difference between the magnetic field (14') and the further magnetic field.

11. Method as claimed in any of claims 1 to 10, comprising a step of producing at least one second dedicated conductive-trace structure (13') on the substrate (10) for the purpose of generating a second magnetic field having a known field distribution, sensing the generated second magnetic field by means of the magnetic field sensor (12), and determining the spatial orientation of the component (11) in relation to the substrate (10) on the basis of said sensing of the magnetic field (14') having the known field distribution (14) and of said sensing of the second magnetic field having the known field distribution.

12. The method as claimed in any of claims 1 to 11, wherein the step of applying the electric voltage to the dedicated conductive-trace structure (13) includes the electric voltage to be applied in a reciprocal manner at least once, so that the current flows in the opposite direction at least once and generates an oppositely directed magnetic field having a known field distribution, sensing the oppositely directed generated magnetic field by means of the magnetic field sensor (12), and determining a difference between the generated magnetic field (14') and the generated opposite magnetic field.

13. Method as claimed in any of claims 1 to 12, wherein the step of producing the dedicated conductive-trace structure (13) on the substrate (10) includes producing the dedicated conductive-trace structure (13) on the same side (10a) of the substrate (10) on which also the magnetic field sensor (12) is arranged,

14. Method as claimed in any of claims 1 to 12, wherein the step of producing the dedicated conductive-trace structure (13) on the substrate (10) includes producing the dedicated conductive-trace structure (13) on that side (10b) of the substrate (10) which is located opposite the magnetic field sensor (12).

15. Method as claimed in any of claims 1 to 12, wherein the step of producing the dedicated conductive-trace structure (13) on the substrate (10) includes producing a first portion (13a, 13b, 13c) of the dedicated conductive-trace structure (13) on the same side (10a) of the substrate on which also the magnetic field sensor (12) is arranged, and producing a second portion (13d, 13e, 13f) of the dedicated conductive-trace structure (13) on that side (10b) of the substrate (10) which is located opposite the magnetic field sensor (12).

16. Method as claimed in any of claims 1 to 15, wherein the step of producing the dedicated conductive-trace structure (13) on the substrate (10) includes configuring the dedicated conductive-trace structure (13) as a buried conductive-trace structure (13) integrated into the substrate (10).

17. Device (20) for positioning a component (11) arranged on a substrate (10), the device comprising:
a substrate (10) having arranged thereat at least one magnetic field sensor (12) for sensing a static magnetic field (14'), and for determining the spatial orientation of the component (11) in relation to the substrate (10),
a dedicated conductive-trace structure (13) formed on the substrate (10), said dedicated conductive-trace structure (13) being provided for the purpose of generating a static magnetic field (14') having a known field distribution (14),
wherein the dedicated conductive-trace structure (13) is configured to generate, upon application of an electric voltage, the static magnetic field (14') having the known field distribution (14), and
an evaluation device configured to sense the generated static magnetic field (14') by means of the magnetic field sensor (12) and to determine the spatial orientation of the component (11) in relation to the substrate (10) on the basis of said sensing of the static magnetic field (14') having the known field distribution (14).

## Revendications

1. Procédé de détermination de la position d'un composant (11) disposé sur un substrat (10), dans lequel le procédé présente les étapes suivantes consistant à:
prévoir un substrat (10) avec au moins un capteur de champ magnétique (12) disposé sur ce dernier destiné à détecter un champ magnétique statique (14') et à déterminer l'orientation spatiale du composant (11) par rapport au substrat (10),
générer une structure de pistes conductrices à but spécifique (13) sur le substrat (10), où la structure de pistes conductrices à but spécifique (13) est prévue aux fins de générer un champ magnétique statique (14') à répartition de champ connue (14),
appliquer une tension électrique à la structure de pistes conductrices à but spécifique (13) de sorte que la structure de pistes conductrices à but spécifique (13) génère le champ magnétique statique (14') à la répartition de champ connue (14),
détecter le champ magnétique statique généré (14') à la répartition de champ connue (14) à l'aide du capteur de champ magnétique (12) et déterminer l'orientation spatiale du composant (11) par rapport au substrat (10) sur base de la détection du champ magnétique statique (14') à la répartition de champ connue (14).

2. Procédé selon la revendication 1, dans lequel l'étape d'application de la tension électrique comporte le fait qu'il est appliqué une tension continue.

3. Procédé selon l'une des revendications 1 ou 2, dans lequel la tension électrique appliquée à la structure de pistes conductrices à but spécifique (13) est supérieure à une tension électrique utilisée pour l'alimentation en énergie des composants disposés sur le substrat (10).

4. Procédé selon l'une des revendications 1 à 3, dans lequel l'étape consistant à générer la structure de pistes conductrices à but spécifique (13) sur le substrat (10) comporte le fait que la structure de pistes conductrices à but spécifique (13) est générée de sorte qu'elle présente une seule piste conductrice (13a).

5. Procédé selon l'une des revendications 1 à 3, dans lequel l'étape consistant à générer la structure de pistes conductrices à but spécifique (13) sur le substrat (10) comporte le fait que la structure de pistes conductrices à but spécifique (13) est générée de sorte qu'elle présente deux ou plusieurs pistes conductrices (13a, 13b, 13c).

6. Procédé selon la revendication 4 ou 5, dans lequel l'étape consistant à générer la structure de pistes conductrices à but spécifique (13) sur le substrat (10) comporte le fait qu'au moins une piste conductrice (13a) de la structure de pistes conductrices à but spécifique (13) est générée de sorte qu'elle soit conçue comme une ligne droite s'étendant sur le substrat (10).

7. Procédé selon l'une des revendications 1 à 6, dans lequel l'étape consistant à générer la structure de pistes conductrices à but spécifique (13) sur le substrat (10) comporte le fait que la structure de pistes conductrices à but spécifique (13) est générée de sorte qu'elle soit conçue comme une structure de bobines à plusieurs enroulements parallèles.

8. Procédé selon l'une des revendications 1 à 7, dans lequel l'étape consistant à générer la structure de pistes conductrices à but spécifique (13) sur le substrat (10) comporte le fait que la structure de pistes conductrices à but spécifique (13) est générée de sorte qu'elle s'étende immédiatement à côté du capteur de champ magnétique (12).

9. Procédé selon l'une des revendications 1 à 8, dans lequel l'étape consistant à générer la structure de pistes conductrices à but spécifique (13) sur le substrat (10) comporte le fait que la structure de pistes conductrices à but spécifique (13) est structurée dans le substrat (10) au moyen de photolithographie.

10. Procédé selon l'une des revendications 1 à 9, dans lequel l'étape consistant à appliquer la tension électrique comporte le fait que dans une première étape est appliquée une tension électrique avec une première quantité de tension, de sorte que la structure de pistes conductrices à but spécifique (13) génère le champ magnétique (14') à la répartition de champ connue (14), et que dans une deuxième étape qui suit est appliquée une tension électrique avec une deuxième quantité de tension, de sorte que la structure de pistes conductrices à but spécifique (13) génère un autre champ magnétique à répartition de champ également connue, le fait de détecter l'autre champ magnétique généré à l'aide du capteur de champ magnétique (12), et de déterminer l'orientation spatiale du composant (11) par rapport au substrat (10) sur base d'une détermination de la différence entre le champ magnétique (14') et l'autre champ magnétique.

11. Procédé selon l'une des revendications 1 à 10, présentant une étape consistant à générer au moins une deuxième structure de pistes conductrices à but spécifique (13') sur le substrat (10) aux fins de générer un deuxième champ magnétique à répartition de champ connue, à détecter le deuxième champ magnétique généré à l'aide du capteur de champ magnétique (12), et à déterminer l'orientation spatiale du composant (11) par rapport au substrat (10) sur base de la détection du champ magnétique (14') à répartition de champ connue (14) et de la détection du deuxième champ magnétique à répartition de champ connue.

12. Procédé selon l'une des revendications 1 à 11, dans lequel l'étape consistant à appliquer la tension électrique à la structure de pistes conductrices à but spécifique (13) comporte le fait que la tension électrique est appliquée au moins une fois dans les deux directions, de sorte que le courant circule au moins une fois dans la direction opposée et génère un champ magnétique opposé à répartition de champ connue, le fait de détecter le champ magnétique opposé généré au moyen du capteur de champ magnétique (12) et de déterminer une différence entre le champ magnétique généré (14') et le champ magnétique opposé généré.

13. Procédé selon l'une des revendications 1 à 12, dans lequel l'étape consistant à générer la structure de pistes conductrices à but spécifique (13) sur le substrat (10) comporte le fait que la structure de pistes conductrices à but spécifique (13) est générée sur le même côté (10a) du substrat (10) que celui sur lequel est également disposé le capteur de champ magnétique (12).

14. Procédé selon l'une des revendications 1 à 12, dans lequel l'étape consistant à générer la structure de pistes conductrices à but spécifique (13) sur le substrat (10) comporte le fait que la structure de pistes conductrices à but spécifique (13) est générée sur le côté (10b) du substrat (10) opposé au capteur de champ magnétique (12).

15. Procédé selon l'une des revendications 1 à 12, dans lequel l'étape consistant à générer la structure de pistes conductrices à but spécifique (13) sur le substrat (10) comporte le fait qu'un premier segment (13a, 13b, 13c) de la structure de pistes conductrices à but spécifique (13) est généré sur le même côté (10a) du substrat (10) que celui sur lequel est également disposé le capteur de champ magnétique (12), et qu'un deuxième segment (13d, 13e, 13f) de la structure de pistes conductrices à but spécifique (13) est généré sur le côté (10b) du substrat (10) opposé au capteur de champ magnétique (12).

16. Procédé selon l'une des revendications 1 à 15, dans lequel l'étape consistant à générer la structure de pistes conductrices à but spécifique (13) sur le substrat (10) comporte le fait que la structure de pistes conductrices à but spécifique (13) est conçue comme une structure de pistes conductrices enterrée intégrée dans le substrat (10).

17. Dispositif (20) pour déterminer la position d'un composant (11) disposé sur un substrat (10), dans lequel le dispositif (20) présente:
un substrat (10) avec au moins un capteur de champ magnétique (12) disposé sur ce dernier destiné à détecter un champ magnétique statique (14') et à déterminer l'orientation spatiale du composant (11) par rapport au substrat (10),
une structure de pistes conductrices à but spécifique réalisée (13) sur le substrat (10), où la structure de pistes conductrices à but spécifique (13) est prévue aux fins de générer un champ magnétique statique (14') à répartition de champ connue (14),
dans lequel la structure de pistes conductrices à but spécifique (13) est conçue pour générer, lors de l'application d'une tension électrique, le champ magnétique statique (14') à répartition de champ connue (14), et
un dispositif d'évaluation qui est conçu pour détecter le champ magnétique statique (14') généré au moyen du capteur de champ magnétique (12) et pour déterminer l'orientation spatiale du composant (11) par rapport au substrat (10) sur base de la détection du champ magnétique statique (14') à répartition de champ connue (14).
